(19) Europäisches Patentamt
European Patent Office
Office européen des brevets

(11) EP 2 357 730 A1

(12) **EUROPEAN PATENT APPLICATION**
published in accordance with Art. 153(4) EPC

(43) Date of publication:
**17.08.2011 Bulletin 2011/33**

(21) Application number: **09826140.7**

(22) Date of filing: **12.11.2009**

(51) Int Cl.:
***H03M 7/30*** *(2006.01)* ***H04N 1/41*** *(2006.01)*

(86) International application number:
**PCT/JP2009/069299**

(87) International publication number:
**WO 2010/055893 (20.05.2010 Gazette 2010/20)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **13.11.2008 JP 2008291540**

(71) Applicant: **Oya Nagato**
**Nagano 389-2502 (JP)**

(72) Inventor: **Oya Nagato**
**Nagano 389-2502 (JP)**

(74) Representative: **Zeitler - Volpert - Kandlbinder**
**Herrnstrasse 44**
**80539 München (DE)**

(54) **METHOD FOR PROCESSING DATA IN TREE FORM AND DEVICE FOR PROCESSING DATA**

(57) There provides a processing circuit including a data processing method and a data processing device which enable reversible processing which data volume can be reduced efficiently and significantly with as little degradation to the original state of the data as possible when reconstructing the data information. The data processing method reversibly processing data information input to a data processing device (1) by a processing unit (2) including a data volume reducing unit (3) reducing a data volume of the data information, and a developing unit (4) reconstructing data information reduced in the data volume reducing unit (3). The processing unit (2) is structured by overlaying processing layers (5) formed of a plurality of cells (c). The data volume reducing unit (3) performs unit processing on each of the plurality of cells (c) having the data information. The unit processing performs identification processing according to equivalence and distance of data from a cell group (6) adjacent to the cells (c), and reduces the cells (c) by each of the processing layers (5) in an order from a lower layer to an upper layer of the processing layers (5) until a data position existing on a time axis of the cells (c) stops to thereby reduces the data volume.

Fig.8

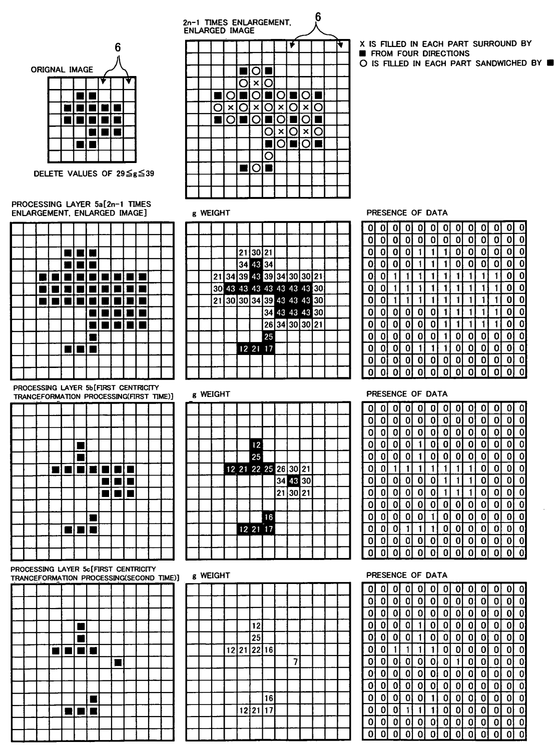


EP 2 357 730 A1

## Description

TECHNICAL FIELD

The present invention relates to a data processing method and a data processing device for processing input data information, and more particularly relates to a data processing method and a data processing device which enable reversible processing by which the volume of data can be reduced efficiently with as little degradation to the original state of data as possible when data of an image, sound, logic, control, and so on which are compressed for transmission or the like are reconstructed.

BACKGROUND ART

Currently, an image of one screen represented on a display with, for example, 600 vertical dots and 400 horizontal dots in an electronic apparatus such as a personal computer has an enormous total data amount of $600 \times 400 \times 256^3$, given that 1 dot on the screen has 24-bit color information. When such an image is transmitted via communication means such as the Internet, CPU processing for processing the vast amount of data takes time, and a large amount of memory resource is consumed. Thus, there are techniques for reducing the volume of data by compressing data of the original image in various formats.

As one of such compression techniques, for example, JPEG (Joint Photographic coding Experts Group), GIF (Graphics Interchange Format), and so on are widely used, as described in Patent Document 1 or the like. The JPEG format is such that image data are converted into a frequency, and when such frequency data are quantized, high-frequency components having a low amount of data compared to low-frequency components become 0 by quantization, and the overall data volume is compressed by this amount. Further, in the GIF format, an image is scanned line by line in a horizontal direction, and portions in which the same color is repeated are grouped, thereby achieving compression of the total data volume.

Patent Document 1: International Publication No. 2004/56084

Non-patent Document 1: J. Neuroscience vol. 19 p. 8036-8042, Reconstruction of Natural Scenes from Ensemble Responses in the Lateral Geniculate Nucleus, 1999

DISCLOSURE OF THE INVENTION

PROBLEMS TO BE SOLVED BY THE INVENTION

In conventional compression methods enabling various types of reversible compression, such as the aforementioned JPEG format and GIF format, degradation of image occurs more than a little when the compressed data are reconstructed, due to noise generated in data compression, compression exceeding supported color number, extraction of portions with the same attribute in a predetermined range, and so on. Accordingly, there is desired a capability of reducing the data volume of an image with as little degradation of the original image as possible, and studies aiming at further improvement in precision and compression rate are conducted every day with these compression methods.

The present inventor was astonished by a study in a previously released paper (Non-patent Document 1 above) such that a human sees an image of a "flower" or the like seen through the visual cortex while keeping the original shape by beautifully turning the flower into a tree form via in-brain processing. This is an image obtained by checking 1 77 neurons in the visual cortex with a tester and reconstructing them. In this brain, processing of information of the image and so on is performed efficiently through respective layers of neurons formed of a multi-layer structure.

Accordingly, the present inventor has completed a novel image processing form and processing method resembling brain synapses by which the volume of data can be reduced with little degradation of the original image by applying a processing mode of information obtained from visual perception in a brain and using this mode with computer technology.

Therefore, a proposition of the present invention is to provide a data processing method and a processing circuit including a data processing device which both enable reversible processing by which the volume of data of an image, sound, logic, control, and so on can be reduced efficiently and significantly with as little degradation to the original state of the data as possible when the data are reconstructed.

MEANS FOR SOLVING THE PROBLEMS

Therefore, the invention described in claim 1 is a data processing method reversibly processing data information input to a data processing device by a processing unit including a data volume reducing unit reducing a data volume of the data information, and a developing unit reconstructing data information reduced in the data volume reducing unit, in which the processing unit is structured by overlaying processing layers formed of a plurality of cells; the data volume reducing unit performs unit processing on each of the plurality of cells having the image information; and the unit processing performs identification processing according to equivalence and distance of data from a cell group adjacent to the cells, reduces the cells by each of the processing layers in an order from a lower layer to an upper layer of the processing layers until a data position existing on a time axis of the cells stops (hereinafter abbreviated as remain) to thereby reduces the data volume, and controls recording and analyzing of the data.

The invention described in claim 2 is the data processing method according to claim 1, in which the method sets a cell which needs to determine whether or not a reduction of the cells is performed as a center cell, and sets a plurality of cell groups existing around the center cell as a group, in which the group is made by simplifying and unifying an operation of a neuron synapse and enables parallel processing by combining the cells.

The invention described in claim 3 is the data processing method according to claim 1, in which the data volume reducing unit further reduces the center cell located at end points of a straight line coupling the center cell being remained in the processing layers to be perpendicular to the processing layers.

The invention described in claim 4 is the data processing method according to claim 1, in which the cells record a reduction status of the data information.

The invention described in claim 5 is the data processing method according to claim 1, in which the data volume reducing unit reduces the data information of n dimension in n-dimensional space to data information of (n-1)-dimensional composite body in (n+1)-dimensional space.

The invention described in claim 6 is the data processing method according to claim 1, in which the data volume reducing unit reduces the data information of (n-1) dimension in (n+1)-dimensional space to 0-dimensional (point form) data information on $2^{n-1}$(n+1) dimension.

The invention described in claim 7 is the data processing method according to claim 1, in which the identification processing is weighting processing of assigning and adding a weight.

The invention described in claim 8 is the data processing method according to claim 1, in which the developing unit reconstructs the cells being reduced in order from the upper layer to the lower layer of the processing layers.

The invention described in claim 9 is the data processing method according to claim 1, in which the processing unit reduces and develops the data information for each similar data.

The invention described in claim 10 is the data processing method according to claim 1, in which the recording control unit is a method transforming a tree-formed data structure into a pulse signal and a method inputting/outputting and controlling data to retrieve and construct a tree-formed structure from the pulse signal.

The invention described in claim 11 is the data processing method according to any one of claims 1 to 10, in which the analysis controlling unit is a method controlling a flow of other data by performing data masking on a circuit.

the invention described in claim 12 is a data processing device reversibly processing data information input to a data processing device by a processing unit including a data volume reducing unit reducing a data volume of the data information, and a developing unit reconstructing data information reduced in the data volume reducing unit, in which the processing unit is structured by overlaying processing layers formed of a plurality of cells; the data volume reducing unit performs unit processing on each of the plurality of cells having the data information; and the unit processing performs identification processing by a weight according to equivalence and distance of data from a cell group adjacent to the cells, reduces the cells by each of the processing layers in an order from a lower layer to an upper layer of the processing layers until a data position existing on a time axis of the cells stops to thereby reduces the data volume, and controls recording and analyzing of the data.

The invention described in claim 13 is the data processing device according to claim 12, in which the data volume reducing unit further reduces the center cell located at end points of a straight line coupling the center cell being remained in the processing layers to be perpendicular to the processing layers.

The invention described in claim 14 is the data processing device according to claim 12, in which the data volume reducing unit reduces the data information of n dimension in n-dimensional space to data information of (n-1)-dimensional composite body in (n+1)-dimensional space.

The invention described in claim 15 is the data processing device according to claim 12, in which the data volume reducing unit reduces the data information of (n-1) dimension in (n+1)-dimensional space to 0-dimensional point form data information in 2n-'(n+1)-dimensional space.

The invention described in claim 16 is the data processing device according to claim 12, in which the developing unit reconstructs the cells being reduced in order from the upper layer to the lower layer of the processing layers.

The invention described in claim 1 7 is the data processing device according to claim 12, in which the recording control unit of the data is a method transforming a tree-formed data structure into a pulse signal and inputs/outputs and controls data to retrieve and construct a tree-formed structure from the pulse signal.

The invention described in claim 18 is the data processing device according to claim 12, in which the analysis controlling unit of the data controls a flow of other data by performing data masking on a circuit.

The invention described in claim 19 is the data processing method and the data processing device according to any one of claims 1 to 18, in which the data information is an image, a sound, logic, and control.

EFFECTS OF THE INVENTION

The invention described in claim 1 is a data processing method reversibly processing data information input to a data processing device by a processing unit formed of a data volume reducing unit reducing a data volume of the data information, and a developing unit reconstructing data information reduced in the data volume reducing unit, in which the processing unit is structured of overlaid processing layers formed of a plurality of cells; the data volume reducing unit performs unit processing on each of the plurality of cells having the data information; and in the unit processing, identification processing is performed according to equivalence and distances of data from a cell group adjacent to the cells, the cells are reduced in each processing layer in order from a lower layer to an upper layer of the processing layers until a center cell which is a point on an image on which attention is focused is left to thereby reduce the data volume, and recording and analyzing of these data are controlled. Thus, data information of an image, sound, logic control, and so on in units of cell groups can be subjected to the unit processing of serial type in the order of processing layers similarly to in-brain processing, and the congeneric ratio in a cell group can be determined to reduce center cells. Accordingly, the data information can be reduced quickly and efficiently. Therefore, it is possible to provide a data processing method by which the volume of data can be reduced efficiently.

In the invention described in claim 2, a cell where it is needed to determine presence of reduction of the cells is defined as a center cell, a plurality of cell groups existing around the center cell is defined as a group, the group is made by simplifying and unifying operation of neuron synapse, and the cells are combined to enable parallel processing. Thus, data information can be reversibly processed efficiently. Therefore, it is possible to provide a data processing method by which the volume of data can be reduced efficiently.

In the invention described in claim 3, the data volume reducing unit further reduces the center cell located at end points of a straight line coupling the center cells remaining in the processing layers to be perpendicular to the processing layers. Thus, in center cells which are reduced and left as first centricity transformation processing, the data volume can be reduced more by further reducing a part of these center cells as much as possible. Therefore, it is possible to provide a data processing method by which the volume of data can be reduced efficiently and largely.

Here, as a transmission condition, as illustrated in Fig. 1 which is a schematic diagram illustrating flow of data by the data processing method of the present application invention, cells c exit in a layer form in a state like piecrusts of a sweet stuff, and interference of data in processing layers 5 is prohibited. However, transmission of data to the next processing layer 5 is allowed. Further, as another transmission condition, when signals are not synchronous, that is, base time S < At = |t1 (first signal from surrounding cells in an upward direction) - t2 (last signal from the surrounding cells in the upward direction) is true, the cells do not transmit a signal to the next processing layer. Moreover, as illustrated in Fig. 2 which is an explanatory diagram of a reduction pattern of center cells, as a transmission condition, the surrounding cells c which can determine whether to transmit a data signal to the next processing layer by the load sum g of a data signal from the cells c of the previous processing layer are weighted, the weights of the cells c are added to judgment values when surrounding data exist, and the judgment values are compared, to thereby determine whether to transmit information or not. As determination regarding the load sum g of the cells c, there are three patterns of $0 \leq g < L$ (lowest reference value), $L \leq g \leq H$ (highest reference value), and $H < g \leq Max$ (maximum value). However, when data of center cells do not exist, g is set to 0.

In the invention described in claim 4, the cells record a reduction status of the data information by the form of positions of individual cells. Thus, when data information is reconstructed by the developing unit, cells reduced based on this record can be easily and quickly reconstructed. Therefore, it is possible to provide a data processing method by which data information can be reconstructed efficiently and quickly.

In the invention described in claim 5, the data volume reducing unit reduces the data information of n dimension in an n-dimensional space to data information of (n-1)-dimensional composite body in (n+1)-dimensional space. Thus, when an image of ellipse or square shape having planar, two-dimensional information on a display for example is represented by a time axis as processing between processing layers, it becomes simple one-dimensional linear image information, and the image information can be reduced efficiently during transmission through the processing layers. Therefore, it is possible to provide a data processing method by which the data volume can be reduced efficiently.

In the invention described in claim 6, the data volume reducing unit reduces the data information of (n-1) dimension in a (n+1)-dimensional space to 0-dimensional data information in a $2^{n-1}(n+1)$-dimensional space. Thus, the image information can be reduced efficiently during transmission through the processing layers. Therefore, it is possible to provide a data processing method by which the data volume can be reduced efficiently.

In the invention described in claim 7, the identification processing is weighting processing of assigning and adding a weight. Thus, weighting the cells forming one cell group by largeness/smallness of numeric values enables quick and easy identification of each cell and center cell. Thus, reduction and reconstruction processing of each cell can be performed quickly. Therefore, it is possible to provide a data processing method which enables reversible processing by which the volume of data can be reduced and reconstructed efficiently and quickly.

In the invention described in claim 8, the developing unit reconstructs the reduced cells in order from an upper layer to a lower layer of the processing layers. Thus, with the center cell of each cell group being a base point, cells which have been reduced can be securely and quickly reconstructed in the order of closeness to this center cell. Therefore, it is possible to provide a data processing method by which data information can be reconstructed efficiently and quickly.

In the invention described in claim 9, the processing unit reduces and develops the data information for every similar data. Thus, the data volume can be reduced more efficiently. Therefore, it is possible to provide a data processing method by which the data volume can be reduced efficiently.

In the invention described in claim 10, control of recording and analyzing data includes a method for transforming a tree-formed data structure into a pulse signal and a method for inputting/outputting and controlling data for retrieving and constructing a tree-formed structure from a pulse signal. Thus, with a reduced data volume, data can be stored and called efficiently and quickly. Therefore, it is possible to provide a data processing method by which the data volume can be reduced efficiently.

In the invention described in claim 11, control of recording and analyzing data controls flow of other data by performing data masking in a circuit. Thus, with a reduced data volume, data can be stored and called efficiently and quickly. Therefore, it is possible to provide a data processing method by which the data volume can be reduced efficiently.

The invention described in claim 12 is a data processing device reversibly processing data information input to a data processing device by a processing unit formed of: a data volume reducing unit reducing a data volume of the data information; and a developing unit reconstructing data information reduced in the data volume reducing unit, in which: the processing unit is structured of overlaid processing layers formed of a plurality of cells; the data volume reducing unit performs unit processing on each of the plurality of cells having image information; and in the unit processing, identification processing is performed by assigning and adding a weight according to equivalence and distances of data from a cell group adjacent to the cells, the cells are reduced in each processing layer in order from a lower layer to an upper layer of the processing layers until a data position existing on a time axis of the cells stops to thereby reduce the data volume, and recording and analyzing of these data are controlled. Thus, data information in units of cell groups can be subjected to the serial processing in the order of processing layers similarly to in-brain processing, and the congeneric ratio in a cell group can be determined to reduce center cells. Accordingly, the data information can be reduced quickly and efficiently. Therefore, it is possible to provide a data processing device by which the volume of data can be reduced efficiently.

In the invention described in claim 13, the data volume reducing unit further reduces the center cell located at end points of a straight line coupling the center cells remaining in the processing layers to be perpendicular to the processing layers. Thus, in center cells which are reduced and left as first centricity transformation processing, the data volume can be reduced more by further reducing a part of these center cells as much as possible. Therefore, it is possible to provide a data processing device by which the volume of data can be reduced efficiently and largely.

In the invention described in claim 14, the data volume reducing unit reduces the data information of n dimension in an n-dimensional space to data information of (n-1)-dimensional composite body in (n+1)-dimensional space. Thus, when data of an image of ellipse or square shape or the like having planar, two-dimensional information on a display for example is represented by a time axis as processing between processing layers, it becomes simple one-dimensional linear data information, and the data information can be reduced efficiently during transmission through the processing layers. Therefore, it is possible to provide a data processing device by which the data volume can be reduced efficiently.

In the invention described in claim 15, the data volume reducing unit reduces the data information of (n-1) dimension in a (n+1)-dimensional space to 0-dimensional point form data information in a $2^{n-1}(n+1)$-dimensional space. Thus, the image information can be reduced efficiently during transmission through the processing layers. Therefore, it is possible to provide a data processing device by which the data volume can be reduced efficiently.

In the invention described in claim 16, the developing unit reconstructs the reduced cells in order from an upper layer to a lower layer of the processing layers. Thus, with the center cell of each cell group being a base point, cells which have been reduced can be securely and quickly reconstructed in the order of closeness to this center cell. Therefore, it is possible to provide a data processing device by which data information can be reconstructed efficiently and quickly.

In the invention described in claim 17, control of recording and analyzing data is a method for transforming a tree-formed data structure into a pulse signal and inputs/outputs and controls data for retrieving and constructing a tree-formed structure from a pulse signal. Thus, with a reduced data volume, data can be stored and called efficiently and quickly. Therefore, it is possible to provide a data processing device by which the data volume can be reduced efficiently.

In the invention described in claim 18, control of recording and analyzing data controls flow of other data by performing data masking in a circuit. Thus, with a reduced data volume, data can be stored and called efficiently and quickly. Therefore, it is possible to provide a data processing device by which the data volume can be reduced efficiently.

In the invention described in claim 19, the data information is an image, sound, logic, and control. Thus, largely reducing general data information allows to efficiently transmit/receive such data information. Therefore, it is possible to provide a data processing method and a data processing device by which the volume of data can be reduced efficiently.

BRIEF DESCRIPTION OF THE DRAWINGS

Fig. 1 is a schematic diagram illustrating flow of data by a data processing method of the present application invention.
Fig. 2 is an explanatory diagram of a reduction pattern of center cells.
Fig. 3 is a schematic structural diagram of a processing unit including a data processing method in a data processing device of the present invention.
Fig. 4 is a schematic diagram of the processing unit, in which upper and lower layers (5a, 5b, ...) are overlaid in a reverse direction for easiness of viewing.
Fig. 5 is an original image illustrating ellipses as an example of performing data processing using the data processing method in the data processing device of the present invention.
Fig. 6 is an identification example of cells with respect to one group of cells and a process diagram of cell reduction performed for each processing layer.
Fig. 7 is an enlarged diagram of groups of cells located in a part of ellipse image information.
Fig. 8 is a reduction process diagram for groups of cells forming a part of ellipse image information.
Fig. 9 is an image obtained by reducing the ellipse image illustrated in Fig. 3 by the data processing method in the data processing device according to the present invention.
Fig. 10 is a perspective view of a processing space.
Fig. 11 is a process diagram of cell reconstruction performed for each processing layer of one group of cells.
Fig. 12 is a process diagram of second processing of groups of cells obtained by performing first processing on a part of ellipse image information.
Fig. 13 is an example of an original image describing reduction of data volume for each of similar colors.
Fig. 14 is a process diagram of reduction of cells performing point-transformation of data information in an image with a similar color.
Fig. 1 5 is an explanatory diagram of a data volume reducing unit which repeats reduction and expansion.
Fig. 16 is a table illustrating one example in which image data of Fig. 1 3 are reduced to be discrete data.
Fig. 1 7 is a table illustrating an example of analyzing data of Fig. 16 in a z-axis direction.
Fig. 18 is a table illustrating an example of analyzing data of Fig. 16 in order from an upper layer to a lower layer.
Fig. 19 is a diagram illustrating processes of centricity transformation processing up to the third on a box having a three-dimensional area as an example of image information.
Fig. 20 is a graph illustrating signals performing reading and writing of a tree-form data structure.
Fig. 21 is a diagram illustrating an example of processing when a threshold is provided.

EXPLANATION OF NUMERALS AND SYMBOLS

| | |
|---|---|
| 1 | Data processing device |
| 2 | Processing unit |
| 3 | Data reducing unit |
| 4 | Developing unit |
| 5, 5a, 5b, 5c, 5d | Processing layer |
| 6, 6a, 6b, 6' | Cell group |
| c | Cell |
| C | Center cell |

BEST MODE FOR CARRYING OUT THE INVENTION

Regarding reduction of information, first, dimension set theory will be described. This theory is made by expanding transformation concept of analysis and forming a general form in consideration of centricity of a set. Transformation using this concept is reversible, for which various application fields such as image compression, artificial intelligence, and so on are conceivable. The n-dimensional continuous area $D^n$ (compact space) existing in the n-dimensional

space $R^n$ is mapping transformed into (n-1)-dimensional continuous area $D^{n-1}$ existing in the (n+1)-dimensional space. Note that the dimension set theory described below is also described schematically in journal of the Japan Society for Symbolic and Algebraic Computation, Vol. 16, No. 2, 18th Convention Lecture "Image compression technology using the centricity concept".

The centricity concept of n-dimensional space which is devised by the patent applicant will be described below.

[Equation 1]

Definition 1

$D^1$ is a compact n-dimensional bounded closed set.

There is an n-dimensional spherical bounded closed set S(pi, $r_i$) having a radius $r_i$ with an inner point of a certain $D^0$, point $p_i$ being a center point, where i is an arbitrary integer.

At this time, distances $r_i$ from two points $x_{i1}^n$, $x_{i2}^n$ present on a boundary $\partial D^n$ are equal, that is,

$$r^i = dist(x_{i1}, p_i)\, and\, r_i = dist(x_{i2}, p_i)\, and\, S(p_i, r_i) \subseteq D^n$$

$$\forall x_{i1} \in \partial D \quad \exists p_i \in Ind(D^n), \quad x_{i2} \in \partial S(p_i, r_i) \subseteq D^n, \quad r_i \geqq 0$$

$$x_{i1}, \quad x_{i2} \in \partial D^n$$

$$S(p_i, r_i) \subseteq D^n$$

$$x_{i1}, \quad x_{i2} \in \partial S(p_i, r_i)$$

When Max($r_i$) = Min($r_i$) = 0, area $x_{i_1} = x_{i_2} = p_i$ is not smooth.

When Max($r_i$) > 0, $x_{i_1} \neq x_{i_2}$ and the area is smooth. In this case, there is always at least one point $x_{i_2}$ corresponding to the point $x_{i_1}$ of the boundary $\partial D^n$, and the point $p_i$ and the distance $r_i$ satisfying the above description are always present within $D^n$.

In other words, a sphere S($p_i$, $r_i$) internally touching two points of $\partial D^n$ always exists.

[Equation 2]

As definition 2, centricity transformation will be described.

$r_i = \{x_{n+1}\}$ obtained by definition 1 is expanded to coordinates $p_i = \{x_i, x_2, ..., x_n\}$, and defined as $P_i = \{x_1, x_2, ..., x_n, x_{n+1}\}$. At this time, a linear area in two closed areas [$x_{i_1}$, $p_i$], $x_{i_2}$, $p_i$] can be replaced with a point of $P_i$.

This transformation is defined as centricity transformation δ.

Next, as theorem 1, centricity transformation from n-dimensional space n-dimensional continuous area $D^n$ to (n+1)-dimensional space n-1 or less dimensional continuous area $Dn^{-1}$ will be described.

$$\forall D^n \subseteq R^n \quad \exists\, \delta(D^n),$$

$$i_j,\ p_j,\ 1 \leqq j \leqq n \subset NaturalNumber$$

$$D^n \Rightarrow \bigcup_{i_1=1}^{p_1} D_{i_1}^{n-1} \cup \bigcup_{i_2=1}^{p_2} D_{i_2}^{n-2} \cup \dots \cup \bigcup_{i_n=1}^{p_n} D_{i_n}^{0} = \bigcup_{j=1}^{n} \bigcup_{i_j=1}^{p_j} D_{i_j}^{n-j} \subset R^{n+1}$$

The n-dimensional continuous area $D^n$ present in the n-dimensional space $R^n$ is δ-transformed, and $\sum_{j=1}^{n} p_i$ number of n-1 present in (n+1)-dimensional space $R^{n+1}$ can be transformed into 0-dimensional continuous composite area $D_i^{n-j}$.

$$
\begin{array}{ccc}
D^{n} & \square & R^{n} \\
\delta(D^{n}) \downarrow & & \\
\bigcup_{j=1}^{n} \left( \bigcup_{i_j=1}^{p_j} D^{n-j}_{i_j} \right) & \square & R^{n\square 1}
\end{array}
$$

A portion where areas overlap exists, and this portion is a coupling portion which is n-2 or less dimensional.

$$
\bigcap_{i_j=1}^{p_j} D^{n-j}_{i_j} = \bigcup_{k_1=1}^{s_1} T^{n-j-1}_{k_1} \square \bigcup_{k_2=1}^{s_2} T^{n-j-2}_{k_2} \cup \ldots \cup \bigcap_{k_{n-j}=1}^{s_{n-j}} T^{0}_{k_{n-j}} = \bigcup_{h=1}^{s_h} \left( \bigcup_{k_h=1}^{s_h} T^{n-j-h}_{k_h} \right) , \bigcap_{k_h=1}^{s_h} T^{0}_{k_h}
$$

$= \Phi$ empty set

There exist $\sum_{j=1}^{n} R_j$ number of uniformly continuous areas and s number of coupling portions. $T^{n-2}_{k}$ refers to a coupling portion of $D^{n-1}_{a}$ and $D^{n-1}_{b}$.

[Equation 3]

Further, inverse transformation will be described as theorem 2.
There exists inverse transformation $\delta^{-1}$, which is defined uniquely.

$$
\begin{array}{ccc}
D^{n} & \square & R^{n} \\
\uparrow \square^{1} \left( \bigcup_{j=1}^{n} \left( \bigcup_{i_j=1}^{p_j} D^{n-j}_{i_j} \right) \right) & & \\
\bigcup_{j=1}^{n} \left( \bigcup_{i_j=1}^{p_j} D^{n-j}_{i_j} \right) & \square & R^{n\square 1}
\end{array}
$$

In this manner, by taking the centricity set, objects in various modes can be grasped from a new aspect.

Further, by changing parameters of transformation into an integer, a real number, and the like, a result which is difficult to be obtained in data processing of an ordinary image can be obtained. As specific examples, as examples of data information, processes to reduce image information of an ellipse contained in a two-dimensional space and a two-dimensional area by replacing with a three-dimensional space and a one-dimensional area will be described later.

Hereinafter, best modes for carrying out the invention will be described with reference to the drawings.
Fig. 3 is a schematic structural diagram of a processing unit including a data processing method in a data processing device of the present invention.

An example of a device 1 for processing data of the present invention is illustrated in Fig. 3. The device 1 for processing data of the present invention internally has a processing unit 2 made up of a data volume reducing unit 3 reducing input data information or the data volume of image information taking an image as an example, and a developing unit 4 reconstructing the image information reduced in this data volume reducing unit 3. Note that in description of the method for processing of the present application, although the data volume reducing unit 3 and the developing unit 4 are illustrated separately for convenience, practically information is reduced and reconstructed in the input direction of the image information by processing in the processing unit 2.

Further, although not particularly limited, the device 1 for processing data of the present invention refers to, for example, a device capable of displaying a figure, painting (including a hand-written one), picture, or the like as a still image or moving image on a display of a personal computer, digital still camera, or the like for example.

There is routinely performed taking an actual image into a processing unit of a data processing device as image information and displaying the image on a display, or transmitting the image information from another data processing device taking in the image information via communication means such as the Internet, a recording medium such as USB (Universal Serial Bus) memory, or the like, and taking the image information into the processing unit of the data processing device and displaying an image on a display.

Here, when the image information of an image having a large amount of information as described above is taken into the processing unit of the data processing device, the data volume of the image information taken in as described above is decreased (reduced) in a data volume adjusting unit of the processing unit, and thereafter this reduced image information is reconstructed to display an image on the display, for reducing the processing time of the CPU, effective utilization of memory resource, and the like. The image information is processed by the known technique as described above.

Now, a specific structure will be described with respect to the data processing method of data information and the data processing device, which are characteristics of the present application invention. Fig. 4 is a schematic diagram of the processing unit. Fig. 5 is an original image illustrating ellipses as an example of performing data processing using the data processing method in the data processing device of the present invention. Fig. 6 is an identification example of cells with respect to one group of cells and a process diagram of cell reduction performed for each processing layer. Fig. 7 is an enlarged diagram of groups of cells located in a part of ellipse image information. Fig. 8 is a reduction process diagram for groups of cells forming a part of ellipse image information. Fig. 9 is an image obtained by reducing the ellipse image illustrated in Fig. 5 by the data processing method in the data processing device according to the present invention. Fig. 10 is a perspective view of a processing space. Fig. 11 is a process diagram of cell reconstruction performed for each processing layer of one group of cells. Fig. 12 is a process diagram of second centricity transformation processing of groups of cells obtained by performing first centricity transformation processing on a part of the ellipse image information.

In the present application invention, there is provided a data processing method enabling reversible processing which is different from conventional ones by using the data volume reducing unit 3 and the developing unit 4 forming the processing unit 2 as a programmed processing circuit for data information of an image or the like, and there is provided a device 1 for processing data including the processing unit 2, which has the data volume reducing unit 3 and the developing unit 4, which reconstructs reduced data information.

This processing unit 2 is structured by overlaying plural processing layers 5 in a sheet form (for example, 128 layers in a depth direction of a screen, or the like), as illustrated in Fig. 4. Further, each of the processing layers 5 is formed of a plurality of cells c which are two-dimensionally laid (in vertical and horizontal directions or the like on the screen), and the arrangement of cells c is identical in all the processing layers 5. Therefore, the processing unit 2 can be in a three-dimensional processing mode (one-dimensional composite body) obtained by adding the overlaying direction of the processing layers 5 to a two-dimensional plane having cells c. In addition, in these cells c, it is assumed that adjacent cells c do not interfere with each other in the processing layers 5.

Next, in the processing layers 5, cells c are grouped into plural cell groups 6 formed of an arbitrary number of cells and arranged in advance. The number (n) of cells c forming the cell groups 6 is $n^2$ (n is an odd number except 1), in which an odd number of cells c are disposed in each of two dimensional directions to obtain a center cell C, which will be described later. In this application, for example, the plural cell groups 6 each formed of 9 cells c are disposed on each processing layer 5. These plural cell groups 6 become active over time accompanying start of processing of image information, and their operation is controlled corresponding to the status of surrounding information.

In addition, when it is performed in a discrete space, the center point cannot be obtained unless a continuous mass is always of an odd number. Accordingly, when a continuous mass of cells containing n columns of same data exists, it is necessary to newly create a cell space between cells, with the new cell space being in a state of having the same attribute as adjacent cells.

Further, the boundary portion is brought into an empty state.

[Equation 4]

☐ : Empty Cell
■ : Cell that black color entered
☐ : Cell that white color entered

When it is one dimensional,

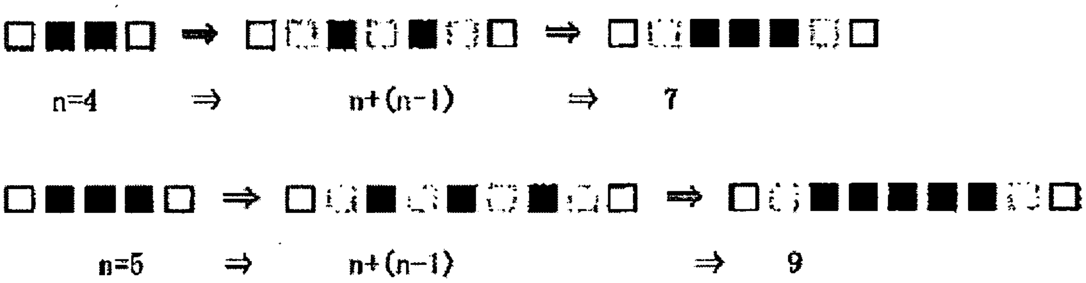


When it is two dimensional,

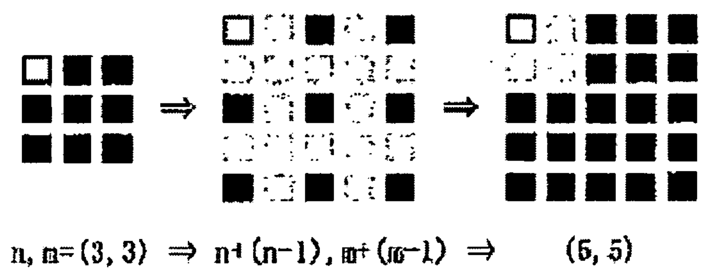


When reconstruction processing is performed later, processing inverse of the above-described processing needs to be performed.

Here, taking an image having an elliptic shape with a two-dimensional plane as an example, a method for processing an image of image information by the processing unit 2 will be described using drawings.

Ellipses of an original image like one illustrated in Fig. 5 are taken into the processing unit 2 as image information in an image processing device 1, such as a personal computer, by a scanner or the like as image information. At this time, the data volume reducing unit 3 starts reducing the data volume in the taken image information. First, respective cells c forming the processing layer 5a located at the lowest layer recognize respective positions corresponding to the original image of the ellipses, and image information of the ellipses is obtained as the entire processing layer 5a.

Next, the data volume reducing unit 3 first causes each of the cell groups 6 grouped in advance in the processing layer 5a to perform unit processing as first centricity transformation processing. Specifically, one cell group 6a formed of nine cells c is assumed as one unit, and this cell group 6a recognizes positions corresponding to the image as image information (and each of the other cell groups recognizes positions corresponding to the image as image information). Then, to each cell c adjacent to the center cell C located at the center in this cell group 6a, a numeric value corresponding to equivalence and distance of data from the center cell C is added as a weight of each cell c, so as to identify each cell c. That is, cells of surrounding $XY\pm1$ are assumed as a deletion judgment group of the center part C, and a weight coefficient is added in reverse proportion to the distance from C. This processing is defined as the first centricity transformation processing.

In the example of Fig. 6, among the nine respective cells c in the cell group 6a, the weight on the center cell C which is located in this cell group 6a and is the center of image information which this cell group 6a has is decided as 7, and thereafter, a small numeric value such as 4 or 5 is added to the eight surrounding cells c in reverse proportion to equivalence and distance of data from the center cell C. Each of the cells c is identified thus. Note that in the example of Fig. 6, the image information is processed as real values.

This identification of each cell c is not limited to the heaviest numeric value accompanying weighting with a numeric value as described above and is variable, and identification with a lightest numeric value or a symbol other than numeric values may be used.

Further, in the other cell groups in the processing layer 5a, identification of the cells c of each cell group 6 is performed similarly.

Next, the data volume reducing unit 3 reduces image information contained in a cell c to which the lightest weight is added, numeric value 4 in this example, among the cells c of the cell group 6a (and each of the other cell groups 6) in the processing layer 5a. At this time, since the image information is reduced, this cell c is stored first as a binary number (0: absent, 1: present) for indicating the presence of information when the information needs to be stored in a recording medium.

Next, the data volume reducing unit 3 moves the image information of the cell group 6a which includes the cells c having the image information (and each of the other cell groups 6) to the cells c of the corresponding cell group 6a (and each of the other cell groups 6) of the next processing layer 5b laid under the processing layer 5a.

Then, the data volume reducing unit 3 reduces the image information contained in the cells c, to which a numeric value 5 is added in this example, among the cells c of the cell group 6a (and each of the other cell groups 6) in the processing layer 5b.

Therefore, in the example of the cell group 6a, it becomes a state that there is no image information in the surrounding cells c other than the center cell C in the second processing layer 5b of the processing layers 5, and thus the unit processing of this cell group 6a is finished in the processing layer 5b. In addition, when the surrounding cells c remain in another cell group 6, subsequently the data volume reducing unit 3 further moves this cell group 6 to a lower processing layer 6 (third layer, fourth layer, ...), and the unit processing to leave the center cell C similarly to the above is performed.

Moreover, in addition to the above-described processing, the data volume reducing unit 3 performs processing to leave the center cell C of each cell group 6 in this cell group or reduce the center cell. This processing is such that, in the above-described cell group 6a, for example, among the nine cells c having a color difference, if four or less cells c including the center cell C are in the congeneric range of the same color difference with respect to other five or more cells c, the data volume reducing unit 3 leaves the center cell C of the cell group 6a in the cell group 6a in a processing layer 5c.

Specifically, as illustrated in the example of Fig. 7, in the weighted cell group 6a, the sum of weights of four congeneric cells c including the center cell C having the same color difference becomes 21, and the sum of weights of the other cells c becomes 22. Thus, the ratio of the same color difference of the four cells c including the center cell C is less than half the color difference of the entire cell group 6a. Therefore, the data volume reducing unit 3 determines that different color differences are mixed in the cell group 6a in the processing layer 5c, and leaves the center cell C in the cell group 6a.

Further, differently from the above description, when five or more cells c including the center cell C among the nine cells c having a color difference in the other cell groups 6 are in the congeneric range of the same color difference with respect to the other four or less cells c, the data volume reducing unit 3 reduces the center cell C of the cell group 6 from this cell group 6 in a processing layer 5 higher than the processing layer 5 in which the center cell C is left.

Specifically, as the example illustrated in Fig. 7, in the weighted cell group 6b, the sum of weights of five cells c including the center cell C having the same color difference becomes 25, and the sum of weights of the other cells c becomes 18. Thus, the ratio of the same color difference of the five cells c including the center cell C is more than half the color difference of the entire cell group 6a. Therefore, the data volume reducing unit 3 determines that the cell group 6a has the same color difference, and reduces the center cell C from the cell group 6 in a processing layer 5 higher than the processing layer 5 in which the center cell C is left. Accordingly, the volume of entire image information can be reduced further.

In addition, the data volume reducing unit 3 may perform the processing to reduce or leave the center cell C according to the ratio of the congeneric range in the cell group 6 in the lowest processing layer 5a in the beginning of the unit processing.

Regarding the image information illustrated in the example of Fig. 6, in which the image of ellipses illustrated (partially illustrated) in Fig. 5 is recognized by the cells c laid across the processing layer 5 by performing the processing as described above, first, the cells c surrounding the center cell C in each cell group 6 are reduced so as to reduce image information contained in these surrounding cells c. Then, when the same color difference range (congeneric range) including the center cell C in each cell group 6 is equal to a set value (assuming that the weight sum is, for example, 22 to 39 as illustrated in Fig. 2), the center cell C of this cell group 6 is reduced so as to reduce image information contained in these center cells C. As a result, as illustrated in a right diagram of Fig. 8, image information formed of point groups of discrete cell groups 6 having the center cell C can be made, in which the data volume of the image is largely reduced. Note that the weight sum values of the respective cell groups and processing layers illustrated in Fig. 8 are presented as an example, and there may be various numeric values depending on images, positions of image information, and so on.

In the processing of the image information as described above, the unit processing of the cell groups 6 is performed in the order of the processing layers 5. Thus, the processing area of the present application is, as illustrated in Fig. 8, a three-dimensional space representing the processing layers 5 (the number of processing layers) extended downward (on the vertical axis) from the upper two-dimensional plane as a time axis (processing time). Further, seeing Fig. 8 from the front, when the respective center cells C of the cell groups 6 which remain in the processing layers 5 accompanying finish of the unit processing are coupled, it becomes a one-dimensional curve.

Therefore, as a result of processing the image information of the ellipse image of a two-dimensional plane as described above, an image with a reduced amount of information as illustrated in Fig. 9 is obtained. In this case, the image information of the reduced ellipse image can be represented by one-dimensional composite bodies each made up of point groups (plane, two-dimensional) along an elliptic shape on the two-dimensional plane representing the center cells C of the cell groups 6 obtained along the elliptic shape, and point groups (time axis, one-dimensional) of a straight line viewing the above-described first-order curve, which is located in the vicinity of the center of the point group of this elliptic shape and coupling the center cells C of the cell groups 6, which indicates the processing layer at the time of finish of the above-described unit processing as a processing time, in the direction from two-dimensional plane above.

Next, to reconstruct the image information which is reduced as described above into an original image inversely to the above description, first, from a lower one of the processing layers 5 in which a center cell C remains, with this center cell C being a base point, the developing unit 4 performs reconstruction processing orderly from a cell c with a heavy weight among the reduced cells c, toward a higher one of the processing layers 5.

As a specific example, regarding the cell group 6a, as illustrated in Fig. 11, with a center cell C left without being reduced (in this case, the center cell C having a weight 7 which is weighted most heavily) in the processing layer 5b being the base point, the developing unit 4 ignites the center cell C (reconstruction processing operation), and thereby the cells c which are located around this center cell C, have a weight 5, and have been reduced are reconstructed based on a reduction record. Note that also in Fig. 11, the image information processed with real values over time is illustrated.

In addition, as described above, in other cell groups 6 in which the center cell C is reduced, the developing unit 4 reconstructs the center cell C in the processing layer 5b in which this center cell C is reduced, and thereafter the center cell C is ignited similarly to the above description, to thereby reconstruct the cells c which have a weight next to the reduced center cell C and are located around this center cell C based on the reduction record.

Next, the developing unit 4 ignites the cells c having a weight 5 in the processing layer 5a, to thereby reconstruct the cells c which have a weight 4, have been reduced, and are located around the cells c having a weight 5 based on the reduction record.

By such reconstruction processing, the image information which has been reduced as illustrated in the right diagram of Fig. 8 illustrating a part of the ellipse is reconstructed to image information as illustrated in a left diagram of Fig. 8. As a result, the image information reduced to the point groups of center cells C illustrated in Fig. 9 taking the ellipse image as an example can be reconstructed to the image information of the original ellipses illustrated in Fig. 5 with good reproducibility.

Note that these one-dimensional composite bodies obtained by reduction can be likened to branches of a tree with no leaf. When image information is reconstructed, it can be likened to a state that a tree is grown thick with leaves attached to these branches. Thus, the method for processing an image of the present application is referred to as a method for processing an image which enables reversible processing in a tree form.

Further, regarding a weight g, data in the range of lower limit L and upper limit U such that the value of g satisfies the following expression $L \leq g \leq U$ are deleted. Alternatively, data are not deleted when the value of g satisfies the following expression $0 \leq g < L$ or $U < g \leq Max$ (maximum value). Here, L and U are variables and need to be changed according to the purpose of processing. When data of cells in center parts are not present, the weight g is also 0. The data type at the time the reconstruction processing is performed changes when the pattern of deletion is in a state as illustrated in Fig. 2.

Further, when center cells are deleted in the range of weight g satisfying the following expression $26 \leq g \leq 39$, reconstruction becomes possible by integer value calculation. In this case, the compression rate is as low as around 50%, but this enables complete reversible processing and can be used in a circuit. Further, this is robust against loss of data, and if a part is damaged, it can be repaired.

Further, when center cells are deleted in the range of weight g satisfying the following expression $22 \leq g \leq 34$, reconstruction needs to be performed by real number calculation. In this case, the compression ratio is as high as about 90%, but this becomes half-reversible processing and can be used in image processing or the like. However, this takes time since the real number calculation is performed when reconstruction is performed.

In addition, when the range of the load sum g of each cell is changed as illustrated in Fig. 2 and center cells C are deleted with the range of g being 26 to 39 for example, many center cells C remain compared to the processing in the tree form, and thus the shape in the processing layer after image information is processed becomes like a complicated tree form. This form can be used in a circuit, and the reduction ratio of data volume is low as compared to the tree form. However, this enables reversible transformation and has a nature that there is no deterioration of information upon reconstruction.

By the processing of image information as described above, the image information can be reduced largely as point groups of center cells C. Further, in the present application, the image information can be reduced further by second centricity transformation processing using the centricity concept such that center cells C obtained through reduction by the above-described first centricity transformation processing are coupled, and center cells C located at end points determined as a straight line are deleted.

In this case, the image information, which is obtained by reducing the image information through the first centricity transformation processing as described with the processing layer 5c of Fig. 8 for example, is used to illustrate a specific example with Fig. 12. Note that the cell groups 6 are located at the same enlarged positions.

Next, to couple on a straight line to enable the two-dimensional centricity processing, regarding enlarged cell groups 6 including a center cell C as in Fig. 12 (a) which are discrete in each processing layer 5 (in this example, the processing layer 5c), the data volume reducing unit 3 makes a determination in a closer area in an upper processing layer 5 (in this example, a processing layer 5d) as illustrated in Fig. 12 (a) for example, and inserts surrounding values in cell positions 6' having a weight of 8 or 10 among the cell groups 6.

Then, in the processing layer 5d, each cell group having data can be coupled on straight lines, and respective cell groups 6, 6' which are end points of these straight lines (in this case, cell groups 6 with a weight of 11 or 12 or at portions of nodes, which are not a straight line) are reduced as illustrated in Fig. 12 (b). Further, in this case, cell groups 6 which are located at respective centers of the discrete cell groups 6, have a weight 17 or 15, and are straight are located in the vicinity of the center of image information and thus are not reduced.

At this time, the cell groups 6, 6' which remain without being created together with the reduced cell groups 6 record a reduction status (reduction direction and so on) as numeric values and the like. Further, numeric values added to the cell group 6, which remains as in the right diagram, indicate the direction and the size of the frame of a cell group as an example of the reduction condition. That is, surrounding cells of XY$\pm$2 are designated as a deletion judgment group of center parts C, and a weight coefficient is added in reverse proportion to the distance from C. This is defined as the second centricity transformation processing.

By the second centricity transformation processing of image information as described above, further from the data volume (number of cell groups 6) of the point group of only cell groups 6 including a center cell C by the first centricity transformation processing as illustrated in Fig. 12 (a), the data volume (number of cell groups 6) of image information illustrating a part of the ellipse image of the left diagram of Fig. 8 becomes the data volume (number of cell groups 6) as illustrated in Fig. 12 (b), and thus the image data volume can be reduced largely.

Further, when the image information having the cell groups 6, 6' reduced by the second centricity transformation processing as described above is reconstructed to the image information base (left diagram of Fig. 12) of the first centricity transformation processing, with the cell groups 6, 6' remaining in the processing layer 5 (in this case, the processing layer 5d) being a base point, the developing unit 4 ignites these cell groups 6, 6', so as to reconstruct the reduced cell groups 6 with good reproducibility based on the record of reduction status of the deleted cell groups 6 and the remaining cell groups 6, 6'. In addition, regarding the above-described processing layers, a separately placed processing layer which is not used in the first centricity transformation processing may be used to perform the second centricity transformation processing.

Regarding the second centricity transformation processing of image information, when an image to be processed in the image processing method which enables reversible processing in a point-tree form of the present application has a three-dimensional area of a box or the like and is a straight object as illustrated in Fig. 19 (a) for example, the first centricity transformation results in a two-dimensional composite body (in a state like a portion in which bubbles adhere to each other) as illustrated in Fig. 19 (b). Next, the second centricity transformation is performed to reduce flat portions, thereby transforming the body into lines illustrated in Fig. 19 (c). In this case, there is created an eight-dimensional space with two time dimensions and six space dimensions. Here, the axis direction may be the same direction as the previous time axis (direction perpendicular to the processing layer). Further, third centricity transformation is performed, center cells are coupled in an arbitrary direction in processing layers located above and below to assume them as a straight line in the processing space, and cells located on end points of this straight line are reduced. As a result, the cells become points in a 1 6-dimensional space illustrated in Fig. 19 (d).

A table is presented below as a reference example for comparing an image data volume reduced by the image processing method by the point-tree form of the present application invention with image data volumes compressed in PNG format and jPEG format as other representative compression formats with respect to the same image.

[Table 1]

| | Point-tree form | PNG | JPEG | Original image (BMP) |
|---|---|---|---|---|
| Image A (hand written) | 728 | 917 | 4852 | 60054 |
| image B (geometric figure) | 754 | 1159 | 6467 | 180054 |
| Unit: byte | | | | |

It is assumed that the tree form includes up to the second centricity transformation processing.
It is assumed that the image A is a relatively simple drawing (monochrome) created arbitrary by hand writing.
It is assumed that the image B is a geometric figure (monochrome) created by a personal computer or the like.

As indicated by the above table, it can be seen that the reduction ratio of image data volume is better with the tree form of the present application invention than the conventional compression formats. Although the target images are limited to the above table and comparison with various images is not made because the present application invention is still in the middle of study, large reduction of a data volume with various images can be expected.

By the structure as described above, image information in units of cell groups can be subjected to the unit processing of serial type in the order of processing layers similarly to in-brain processing, and the congeneric ratio in each cell group can be determined to reduce center cells. Thus, the image information can be reduced quickly and efficiently. Further, with the center cell of each cell group being a base point, cells which have been reduced can be securely and quickly reconstructed in the order of closeness to this center cell. Accordingly, reproducibility of image is high, and it is possible to provide a data processing method and a data processing device which achieve a high reduction rate of image data volume and high reproducibility of image.

Further, by using a data processing method which will be described below, the data volume can be reduced further. Fig. 13 is an example of an original image describing reduction of data volume for each of similar colors. Fig. 14 is a process diagram of reduction of cells performing point-transformation of data information in an image with a similar color. Fig. 15 is an explanatory diagram of a data volume reducing unit which repeats reduction and expansion. Fig. 16 is a table illustrating one example in which image data of Fig. 13 are reduced to be discrete data. Fig. 1 7 is a table illustrating an example of analyzing data of Fig. 16 in a z-axis direction. Fig. 18 is a table illustrating an example of analyzing data of Fig. 16 in order from an upper layer to a lower layer. Fig. 19 is a diagram illustrating processes of centricity transformation processing up to the third on a box having a three-dimensional area as an example of image information. Fig. 20 is a graph illustrating signals performing reading and writing of a tree-form data structure. Fig. 21 is a diagram illustrating an example of processing when a threshold is provided.

Here, for example, data on a cell when data information is reduced in a two-dimensional plane in a two-dimensional space are reduced as follows. First, as illustrated in Fig. 13, image information is an image (IV) formed of an image (I) having a closed area of greens for example as similar colors such as having gradations, and an image (II) having a closed area of reds for example and an image (III) having a closed area of yellows for example as similar colors such as having gradations, which are superposed on the image (I). Areas (continuities of data information) thereof are larger in ascending order of the image (I), the image (II), and the image (III).

First, the processing unit 2 recognizes that the image information is a set of different colors and areas having respective areas formed of similar colors (green [image (I)], red [image (II)], and yellow [image (III)]). Then, in the image information, the data volume reducing unit 3 first reduces the data volume of the image (III) of similar yellows having a smallest area (low continuity of data information). In addition, the image (I), the image (II), and the image (III) are data information present on plural cells c which are two-dimensionally laid on the processing layer 5, as described above.

Like the example of cells c having Fig. 14 (a) and (b) (black squares in the diagram), even number and odd number pieces of data information of the image (II) are lined up in a row N direction and a column M direction. To obtain center points thereof, all information pieces are extended to be odd lines. (The data volume reducing unit 3 performs enlargement transformation of a processing space of cells c illustrated in Fig. 14 (a) from N × M to (N+(N-1)) × (M+(M-1)) as illustrated in Fig. 14 (b). Here, the middle one of Fig. 13 is an enlarged image in which a gap of one pixel can be seen between the images (I) and (II). This is due to that a closed area whose colors are all similar became the same odd number. Further, no value exists in an open part.

Next, like above-described Figs. 6-7, in each of plural overlaid processing layers 5, the data volume reducing unit 3 reduces data information of surrounding cells c and center cells C until there is completely no data to delete, according to the number of data of the surrounding cells c with reference to the center cell C of each cell group 6a as described above, thereby reducing the data volume of the image (III) as illustrated in Fig. 14 (c) for example.

Then, tree-formed data information of the image (III) reduced to this Fig. 14 (c) is moved to plural processing layers 5' overlaid similarly to the above ones, provided separately for each image by color. As illustrated in the middle of Fig. 13, surrounding colors (green of the image (I), and so on) are expanded in empty spaces to fill the spaces generated in the image (III).

At this time, assuming that the image of (IV) of Fig. 13 exists on the screen of Fig. 15(a) similarly to the above description, the data volume reducing unit 3 sequentially reduces the data volumes of the image (II) and image (I) having a small contrast color occupying area, and moves the respective data information to the respective processing layers 5. The series of processing and the structure of the data volume reducing unit 3 are achieved by repeating (b) reduction and (c) expansion as illustrated in Fig. 15 (d). At a lower narrow portion of Fig. 15, the image (III) is moved to another layer. The image (II) is moved to another layer at a middle narrow portion, and the tree-formed data information of the image (I) is moved to another layer at the topmost narrow portion. Finally, the top surface indicates a state that only white remains which is the background.

Next, when cell groups c having data information in the image (III) of the processing layer 5' has an even column as in Fig. 14 (c) for example, in order to obtain a center point, the data volume reducing unit 3 extends the processing space to (2(2N-1) × (2(2M-1)-1) × (2r-1) as in Fig. 14 (d) for example with r being the number of processing hierarchies so that these cell groups c having data information becomes an odd column.

The data volume reducing unit 3 then repeats reduction of cells c located at end points of a straight portion of sequential cell columns c having data information, as in above-described Fig. 12 in each layer of the processing layers 5', thereby reducing the data volume of the image (III) to point groups illustrated in Fig. 14 (e). Therefore, the data volume reducing unit 3 is able to further reduce the data volume of images (III), (II), and (I) by performing processing similar to the above-described one in order on the other images (II) and (I) in the processing layers 5'.

A table is presented below as a reference example for comparing the data volume reduced as described above as the point-tree form (similar color) with image data volumes compressed by the normal tree form as well as PNG format and JPEG format in the same image as the image (IV) described above.

[Table 2]

| | Point-tree form | Tree form | PNG | JPEG | Original image BMP |
|---|---|---|---|---|---|
| Image (IV) | 1349 | 1584 | 1540 | 5480 | 111654 |
| Unit: byte | | | | | |

As indicated by the above table, the tree form and PNG exhibit almost the same value of reduction ratio of image data volume. However, the result of the processing method using the point-tree form (similar color) is higher than the processing method by the tree form and PNG, thereby indicating that the processing method is more excellent.

In the foregoing, reduction of data information by the tree form of the present application invention has been described with examples of image data. However, the data information can be transformed into a tree-form structure also for sound data such as voice and music, so as to largely reduce the data volume thereof.

In this case, in the tree-form structure of sound data, the size of a tree form changes depending on the amplitude and the wavelength of sound. Sound can be decomposed into a frequency and amplitude, and thus the larger the amplitude, the larger the lateral width of the tree form. The branching position of a branch is decided by the ratio of each frequency. Therefore, it becomes possible to easily recognize human voice.

Further, a method to use a resonance instrument having a triangular pyramid structure used for a megaphone or the like to simultaneously capture vibration of sound by frequency and amplitude, or the like is also conceivable. Sound with a long wavelength extends longer in a vertical direction orthogonal to a layer, and sound with a short wavelength extends short in a vertical direction. Further, it is assumed that one with more sound amplitude extends longer in a lateral direction on a layer. The sound is represented with at least a frequency and amplitude and processing thereof is in a two-dimensional space, and thus the sound can always be transformed into one-dimensional data according to the centricity set theory. A tree-form data are formed by a distribution of frequencies.

The tree form of sound data or the like is different in structure from the tree form of image processing. Specifically, the tree form of image data has a broadleaf tree structure, whereas the tree form of sound data or the like has a conifer structure, and there is a difference in whether a layered structure is allowed or not on the same type of information.

That is, the layered structure is not allowed for the same color with respect to image data, but conversely, the layered structure is allowed for certain sound with respect to sound data. This causes the form of data to change between the broadleaf structure and the conifer structure. Further, by repeatedly hearing similar sound, this conifer structure grows to spread horizontally on a layer.

To read and write these tree form data structures, as illustrated in Fig. 20 (a), a pulse signal or a normal distribution signal is used. When signals have equal energy, even when an input is the normal distribution signal which is not the pulse signal, an output signal can be converted into the pulse signal by a method which will be described below.

However, in this method, sound or the like has reversibility, but when two or more dimensional data of image data or the like are processed, it is possible that an image is reconstructed as a mirror image. Thus, it is not exactly reversible transformation unless information of surrounding data is not added.

However, even when there is a difference in direction and size of the tree form, it is easily recognizable. Therefore, recognition of an object or the like can be performed easily by a processed tree form structure.

For reading out, pulses are sent to the inside of a circuit having the tree form structure from the base portion of each tree form, and a part of the pulse signal is returned to the base portion as the source depending on the degree of the angle of a branch. High signal intensity is sent to a direction with high straightness, and the pulse signal is branched at a node portion so that one becomes smaller as its bending angle becomes larger.

Further, at the end portion, the pulse is reflected entirely and all pulse signals are returned to the base portion as the source. Therefore, as illustrated in Fig. 20 (b), for wavelengths of normal distribution type, it becomes short by the ratio of $(\pi - \theta)/\pi$ with respect to the branch angle.

As illustrated in Fig. 20 (c), when a branch is made, proceeding straight with a wavelength ($\sigma$ diverse value) of 0 degree is assumed as onefold, and the 45-degree angle is assumed as 3/4, 90-degree angle as 1/2, 135-degree angle as 1 /4, and 180-degree angle as 0 for considering a reflected wave.

[Equation 5]

Regarding the distribution ratio of signal energy considering a certain variable β, assuming that the signal of a branch direction is signal $\beta_a$ and the signal of a branch direction b is $\beta_b$, and the branch reflection signal is $\beta S_e = \beta\sqrt{}((S_i - S_a)^2 + (S_i - S_b)^2))$, the following equation is conceivable for an input signal $S_i$ and a signal of $(0 < S_i < 1)$.

$$S_i = \beta(S_a^2 + S_b^2 + S_e^2)$$

For example, as illustrated in Fig. 20 (d), considering that a pulse signal having a value of $S_i = 1$ branches into two, one being a straight line and one with a 45-degree angle, the equation is adapted as follows.

$$1 = \beta(1^2 + (3/4)^2 + (1 - 3/4)^2)$$

Accordingly, a straight signal $S_a$ of 0.61 5, a signal $S_b$ branching with 45 degrees of 0.346, and a reflection signal $S_e$ of 0.038 are returned.

This becomes the same value for the tree-form data structure having a similar shape and a different size. Further, the ratio of a signal interval 2a:2(a + c):2(a + b) = A:B:C gives similar results. Therefore, when the signal intensity is the same and the signal interval ratio is the same, it is determined as the data in the same form.

For the reflection wave, the wavelength is assumed as 0 and it becomes a δ function, but re-standardization is performed to make a pulse waveform. Then, the pulse becomes a sequence (waveform) of certain pulses, which can be read out.

Further, becoming pulses makes them easier to be processed. In calculation of the waveform of ordinary normal distribution type, processing of a variance, integration, and so on is difficult. However, for pulses, the input value is simply assumed as 1 and divided according to the ratio, and thus calculation processing can be performed easily.

Further, when the tree-form data structure is written, the system directly processes image, sound, and logic data, or an input signal sequence having a waveform structure which is temporally reverse to an output signal sequence is sent from the tree-form base portion. When a signal with one pulse and amplitude of 1 is returned to the base portion as the origin, it is recognized that writing is completed.

Conversely, to create the tree-formed data structure from a pulse signal sequence with totaled signal strength of 1, a temporally reverse pulse signal waveform is input to a layer to which no data is input, and a traveling direction and a length can be made according to signals of pulses.

Therefore, information from a certain control system is input as a normal distribution waveform having a certain waveform, and one coinciding with the data in the tree-form data is looked for. When there is no coinciding one, the wavelength of the waveform is shortened, and whether there is a coinciding one or not is checked again. This is performed repeatedly, and when it is not present finally, the waveform is changed to a Y-shaped tree-form data structure per unit and recorded separately.

When the circuit is made to react conversely, it becomes possible to transform a certain pulse into a sine wave having a certain amplitude and wavelength, and processing of a control system becomes possible.

Further, as internal processing to perform control, the inside of the processing system is data-masked first, and a signal path is created, in which it is possible to input and process data. Inside the circuit, a color (data) which reached an empty space first is granted the right of possession, and ones that finally become stable in a parallel state can become result data.

In addition, when these tree form transformation processing is performed, only data of similar colors can be processed. Therefore, for a portion which changes gradually such as a sky in a picture like Fig. 21 (a), the following processing is performed. Thresholds are provided, and when colors are in the range of the thresholds, all colors are regarded to be similar (colors) and processed.

When reconstruction is performed, the image can be reconstructed with the similar color data as in Fig. 21 (b). Then, a boundary portion is generated between cells, resulting in collision of different data values. When this happens, if a boundary condition of the threshold + α is met, an average value of boundary values with each other is obtained, the same time as an arrival time from a tree-form point is used, and gradation processing is performed by spreading into the similar colors, thereby reconstructing substantially the original data of Fig. 21 (a).

Next, as a method of storing data in a recording media, the total data volume D of s dimension is defined as

follows.

[Equation 6]

$$D=\prod_{i=1}^{s}L_i=\prod_{i=1}^{s}\sum_{j=1}^{n}M_{ij}=\prod_{i=1}^{s}\sum_{j=1}^{n}\prod_{k=1}^{m}C_{ijk}$$

$i, j, k, L_i, M_{ij}, C_{ijk} \in NaturalNumber$

$L_i$: total amount of cells in one dimension, m: the number of data per cell (3 for RGB).

The volume of data per cell is $M_{ij}=\prod_{k=1}^{m}C_{ijk}\ \ m=3, 0\le C_{ijk}\le 255, 0\le M_{ij}256^3-1$.

The number of cells of all dimensions: $n=\prod_{i=1}^{s}L_i$, the maximum data length of i-dimension: $L_i=\prod_{j=1}^{n}M_{ij}$

Normally, the screen of a personal computer is represented by Xmax × Ymax × COLORmax, and a screen with 600 horizontal pixels and 400 vertical pixels has 24-bit color information $((2^8)^3$ RGB data with Red: 256 gradations, Green: 256 gradations, Blue: 256 gradations) in one pixel (dot) on the screen. Then, when one pixel (dot) is assumed as one cell, the total data volume per screen is $600*400*2^{24}$. This data volume is equal to the volume of a BMP file.

Further, another time axis is assumed as a reaction time t (root time). Here, it is conceivable that a data volume increases simply as the dimension increases, but the processing result would have a decreased data volume unless it is under a situation such that data are not continuous and highly discrete, randomness is at the maximum, and the size does not change when it is compressed.

For sequential data, a root value increases, values of N, M decrease, and the data volume is decreased entirely. The simpler the image is, the more the axis of t (root time) extends and the data volume decreases. The more complicated the image is, the less the axis of t (root time) extends and the data volume decreases.

When data are saved, the data volume always exists even if there is nothing on coordinates. Accordingly, to record discrete data, the number of data becomes much larger than an actually existing value. By using this method, a portion where there is no data can always become one bit. Moreover, the data volume decreases further by performing compression.

Hereinafter, a method for reversibly transforming the point-tree form and storing the result in a file will be described.

In a method for recording discrete information in an n-dimensional integer space as illustrated in Fig. 16 in a file, regarding data information reduced by the tree form or the point-tree form (similar colors), there are stored vertical and horizontal sizes of the data information, the number of maximum processing hierarchies, distances between maximum point groups (data), presence of screen data, and so on by two bits (1, 0) in a file or the like. The order of storing them is such that the number of colors and palette data are stored first in descending order of areas, and then presence of color is stored by two bits in the order of colors only regarding a portion having screen data which is stored previously. Further, regarding a portion having a color, each of fixed length data and variable length data are stored similarly to the order of colors.

Whether it is present or not (1, 0) on a two-dimensional plane which is a projection of certain discrete data on an n dimension is recorded by one bit. However, at this time, it is desired that the recording be performed in a direction in which the number of data contained becomes the minimum value. The direction of projection is tentatively called a Z direction (in this processing system, it is called a root time or widening volume).

As illustrated in Fig. 17, how many data overlap in the Z direction in a portion having data on the two-dimensional plane is measured. However, all the data always become a value of 1 or more, and thus 1 is subtracted in view of data reduction. Further, the number of stored bits is determined from the maximum number thereof, and the number of stored bits and the frequency of overlapping are recorded.

For example, when data are concentrated in an upper layer portion, data are processed layer by layer in order from the upper layer to a lower layer as illustrated in Fig. 18 (when data are concentrated in a lower layer portion, the processing starts from the lower layer portion [in this case, 1 bit is needed as a direction]).

In addition, when there is no data on the Z axis in the lower layer direction from the currently processed layer, data processing in this layer is skipped and the next data processing is performed. If there exist data in the lower layer direction, values of data are stored as 0 when there is no data in the current layer or 1 when there is data, the number of stored bits is determined thereafter from the maximum value of data, and 1 bit of a presence graph of data within layer and a data value graph are recorded.

However, all the data values always become a value of 1 or more, and thus 1 is subtracted in view of data reduction. In the layers, an end is called when all the data seen in the lower layer direction on the Z axis are 0 or when the processing of the lowest layer is finished.

In this manner, by performing similar storage processing by stacking respective data of positions, directions, and distances of reduced data information sequentially in a block shape, the reduced data information are stored efficiently in the aforementioned file or the like.

Further, when an image like one in Fig. 13 is reduced in the above-described point-tree form (similar colors), and data information stored in the aforementioned file or the like is reconstructed (reverse transformation or decompression), the data information of dimension number and the range of coordinates are read from the file and an output space is reproduced. Next, presence of data on the two-dimensional plane is read and reconstruction is performed.

Further, the overlapping frequency data of respective colors are read, and color data are moved in order one by one to the inside of the respective processing layers 5' and added to locations having data on the two-dimensional plane (since 1 is subtracted when data are stored, adding as they are makes them return to the original value).

Then, in order from the upper layer portion, the graph of presence of data within the layer is checked in a portion where the value of the overlapping frequency data is not 0. When there are data, the data are written from the data value graph in this layer, and 1 is subtracted from the overlapping time data. This is performed repeatedly for every color data, and the processing is performed down to the lowest layer. When the developing unit 4 develops the point group data similar to Fig. 14 (e) in a direction-wise and volume-wise manner as illustrated in Fig. 14 (d) in the processing layer 5', and overlays the data from the lower portion at last, the processing is finished. The procedure in this manner reverse to the procedure of the reduction processing enables reconstruction to the image in Fig. 13 with good reproducibility.

In the foregoing, reduction of data information by using the tree form of the present application invention has been described with examples of image data. However, as the data information, also sound data of voice, music, or the like and logic and control are transformed into the tree form structure, and thereby the data volume thereof can be reduced largely.

## Claims

**1.** A data processing method reversibly processing data information input to a data processing device by a processing unit comprising:

a data volume reducing unit reducing a data volume of the data information; and
a developing unit reconstructing data information reduced in the data volume reducing unit, wherein:

the processing unit is structured by overlaying processing layers formed of a plurality of cells;
the data volume reducing unit performs unit processing on each of the plurality of cells having the data information; and
the unit processing performs identification processing according to equivalence and distance of data from a cell group adjacent to the cells, reduces the cells by each of the processing layers in an order from a lower layer to an upper layer of the processing layers until a data position existing on a time axis of the cells stops to thereby reduces the data volume, and controls recording and analyzing of the data.

**2.** The data processing method according to claim 1, wherein
the method sets a cell which needs to determine whether or not a reduction of the cells is performed as a center cell, and sets a plurality of cell groups existing around the center cell as a group, in which the group is made by simplifying and unifying an operation of a neuron synapse and enables parallel processing by combining the cells.

**3.** The data processing method according to claim 1, wherein
the data volume reducing unit further reduces the center cell located at end points of a straight line coupling the center cell being remained in the processing layers to be perpendicular to the processing layers.

**4.** The data processing method according to claim 1, wherein
the cells record a reduction status of the data information.

**5.** The data processing method according to claim 1, wherein

the data volume reducing unit reduces the data information of n dimension in n-dimensional space to data information of (n-1-dimensiona) composite body in (n+1)-dimensional space.

**6.** The data processing method according to claim 1, wherein the data volume reducing unit reduces the data information of (n-1) dimension in (n+1)-dimensional space to 0-dimensional (point form) data information on $2^{n-1}$(n+1) dimension.

**7.** The data processing method according to claim 1, wherein the identification processing is weighting processing of assigning and adding a weight.

**8.** The data processing method according to claim 1, wherein the developing unit reconstructs the cells being reduced in order from the upper layer to the lower layer of the processing layers.

**9.** The data processing method according to claim 1, wherein the processing unit reduces and develops the data information for each similar data.

**10.** The recording control unit is a method transforming a tree-formed data structure into a pulse signal and a method inputting/outputting and controlling data to retrieve and construct a tree-formed structure from the pulse signal.

**11.** The analysis controlling unit is a method controlling a flow of other data by performing data masking on a circuit.

**12.** A data processing device reversibly processing data information input to a data processing device by a processing unit comprising:

a data volume reducing unit reducing a data volume of the data information; and
a developing unit reconstructing data information reduced in the data volume reducing unit, wherein:

the processing unit is structured by overlaying processing layers formed of a plurality of cells;
the data volume reducing unit performs unit processing on each of the plurality of cells having the data information; and
the unit processing performs identification processing by assigning and adding a weight according to equivalence and distance of data from a cell group adjacent to the cells, reduces the cells by each of the processing layers in an order from a lower layer to an upper layer of the processing layers until a data position existing on a time axis of the cells stops to thereby reduces the data volume, and controls recording and analyzing of the data.

**13.** The data processing device according to claim 12, wherein the data volume reducing unit further reduces the center cell located at end points of a straight line coupling the center cell being remained in the processing layers to be perpendicular to the processing layers.

**14.** The data processing device according to claim 12, wherein the data volume reducing unit reduces the data information of n dimension in n-dimensional space to data information of (n-1)-dimensional composite body in (n+1)-dimensional space.

**15.** The data processing device according to claim 12, wherein the data volume reducing unit reduces the data information of (n-1) dimension in (n+1-dimensional space to 0-dimensional point form data information in $2^{n-1}$(n+1)-dimensional space.

**16.** The data processing device according to claim 12, wherein the developing unit reconstructs the cells being reduced in order from the upper layer to the lower layer of the processing layers.

**17.** The data processing device according to claim 12, wherein the recording control unit is a method transforming a tree-formed data structure into a pulse signal and inputs/outputs and controls data to retrieve and construct a tree-formed structure from the pulse signal.

**18.** The data processing device according to claim 12, wherein

the analysis controlling unit controls a flow of other data by performing data masking on a circuit.

**19.** The data processing method and the data processing device according to any one of claims 1 to 18, wherein the data information is an image, a sound, logic, and control.

# Fig.1

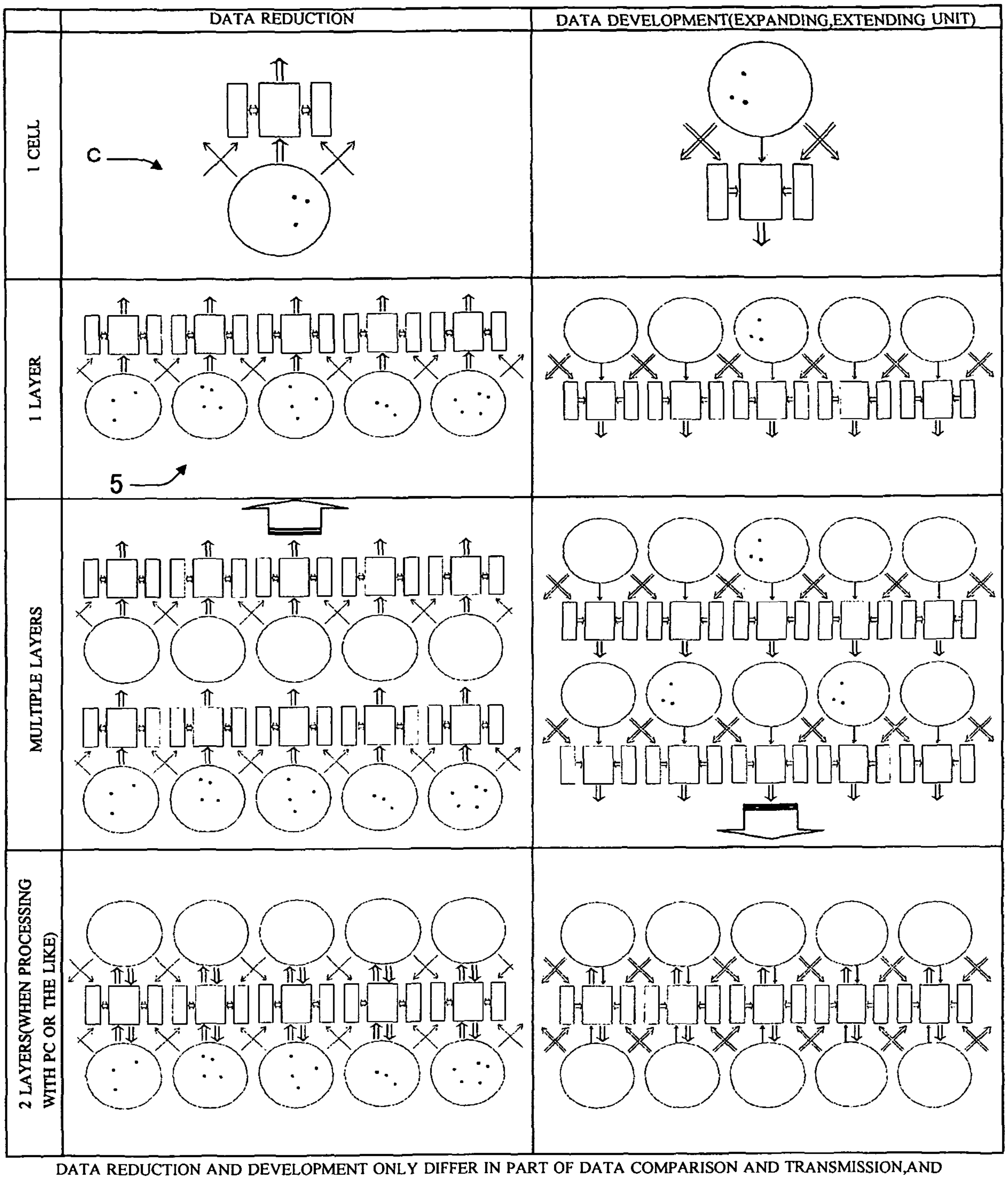


DATA REDUCTION AND DEVELOPMENT ONLY DIFFER IN PART OF DATA COMPARISON AND TRANSMISSION,AND THUS APPROACH TO HAVE SAME PROCESSING CIRCUIT AND CHANGE BY SWITCH MAY BE EMPLOYED

| | |
|---|---|
| DATA STORAGE | ○ |
| PERFORM JUDGMENT | □ |
| DATA FLOW | ⇒ |
| REFERENCE | → |
| COMPARISON | ⇔ |
| DATA | . |

Fig.2

INTEGER TYPE [POSSIBLE TO RECONSTRUCT BY INTEGER TYPE CALCULATION]
(TREE FORM IS COMPLICATED)

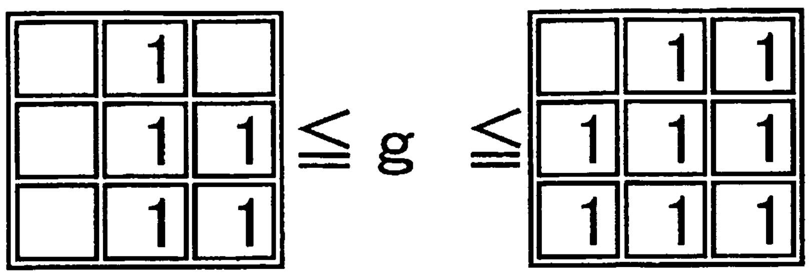

WEIGHT:LARGER THAN 26 WEIGRT:39 OR SMALLER

REAL NUMBER TYPE [POSSIBLE TO RECONSTRUCT BY REAL NUMBER TYPE CALCULATION]
(BRANCH FORM OF TREE)

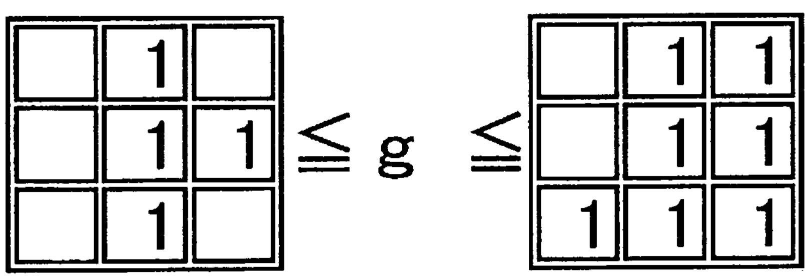

WEIGHT:LARGER THAN 22 WEIGRT:34 OR SMALLER

1 IN CELL REPRESENTS PRESENCE OF DATA

Fig.3

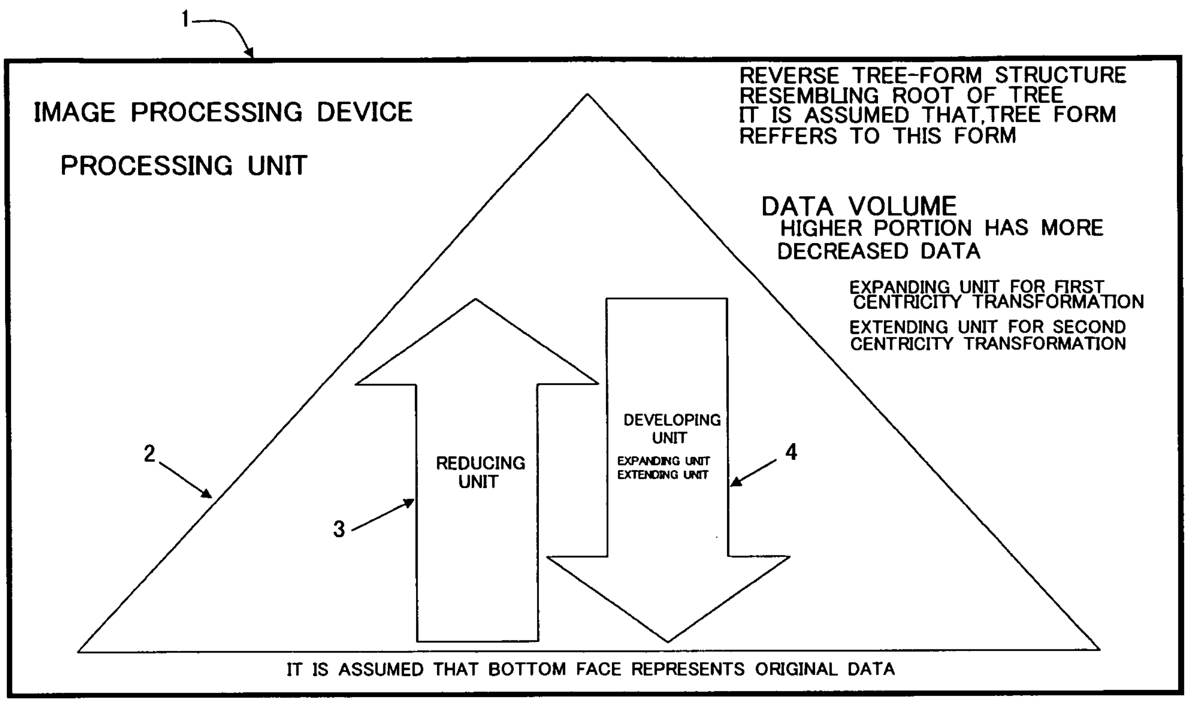
1
IMAGE PROCESSING DEVICE
PROCESSING UNIT
REVERSE TREE-FORM STRUCTURE
RESEMBLING ROOT OF TREE
IT IS ASSUMED THAT,TREE FORM
REFFERS TO THIS FORM
DATA VOLUME
HIGHER PORTION HAS MORE
DECREASED DATA
EXPANDING UNIT FOR FIRST
CENTRICITY TRANSFORMATION
EXTENDING UNIT FOR SECOND
CENTRICITY TRANSFORMATION
REDUCING
UNIT
DEVELOPING
UNIT
EXPANDING UNIT
EXTENDING UNIT
2
3
4
IT IS ASSUMED THAT BOTTOM FACE REPRESENTS ORIGINAL DATA

Fig.4

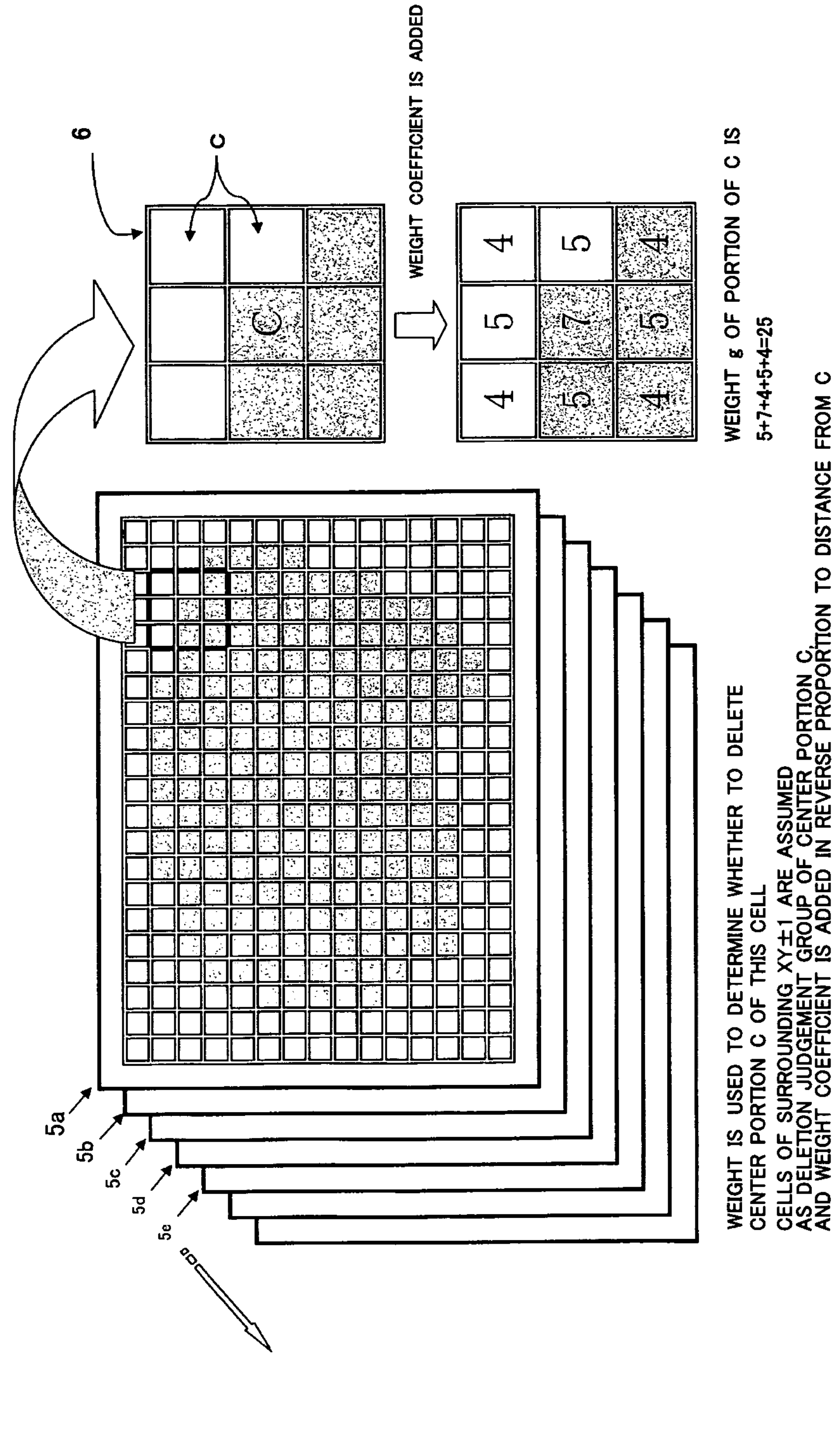
6
C
WEIGHT COEFFICIENT IS ADDED
C
4
5
4
5
7
5
4
5
4
WEIGHT g OF PORTION OF C IS
5+7+4+5+4=25
5a
5b
5c
5d
5e
WEIGHT IS USED TO DETERMINE WHETHER TO DELETE
CENTER PORTION C OF THIS CELL
CELLS OF SURROUNDING XY±1 ARE ASSUMED
AS DELETION JUDGEMENT GROUP OF CENTER PORTION C,
AND WEIGHT COEFFICIENT IS ADDED IN REVERSE PROPORTION TO DISTANCE FROM C

Fig.5

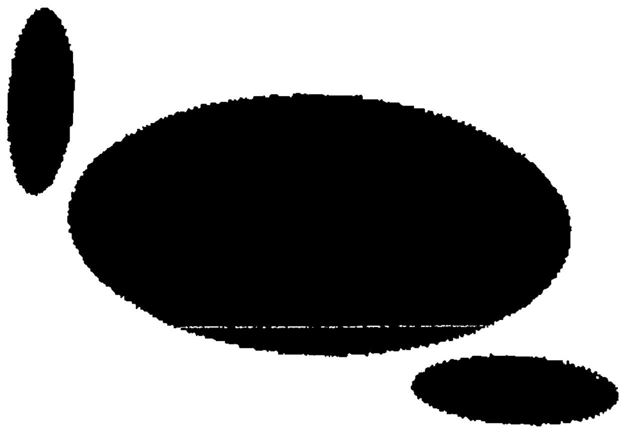

Fig.6

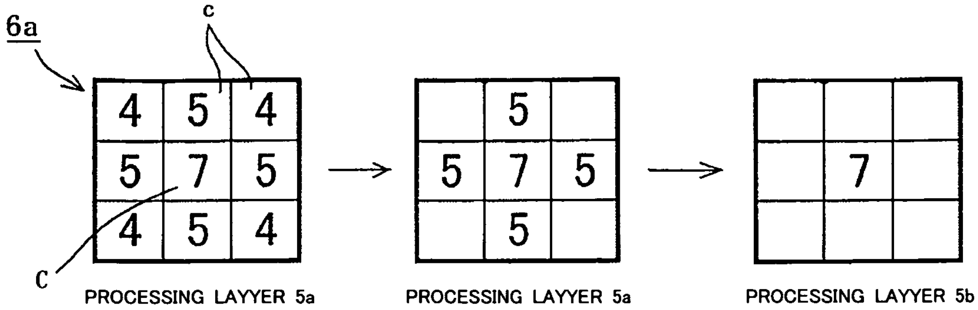
6a
c
4 5 4
5 7 5
4 5 4
C
PROCESSING LAYYER 5a
5
5 7 5
5
PROCESSING LAYYER 5a
7
PROCESSING LAYYER 5b

Fig.7

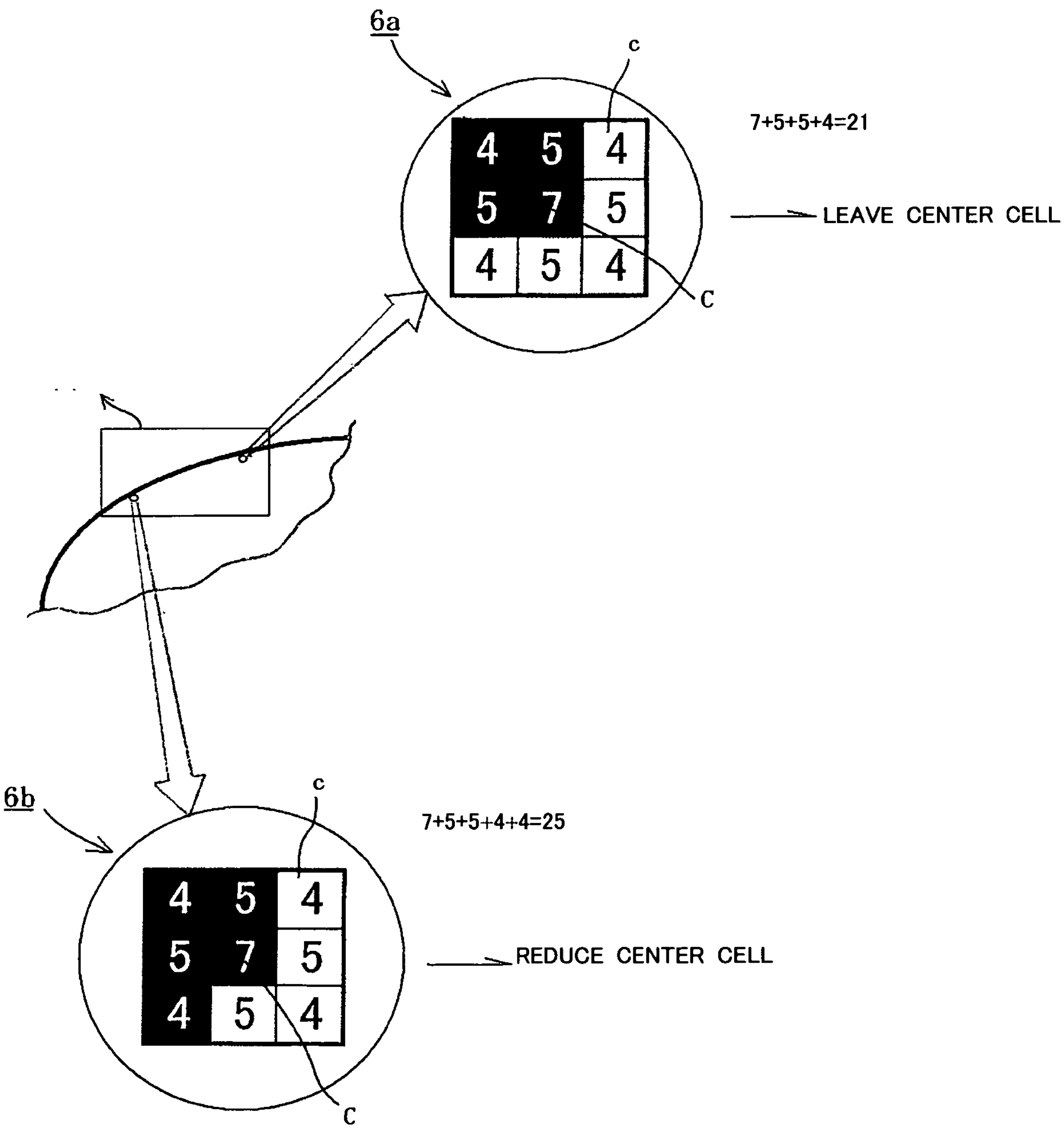
6a
c
4 5 4
5 7 5
4 5 4
C
7+5+5+4=21
LEAVE CENTER CELL
6b
c
4 5 4
5 7 5
4 5 4
C
7+5+5+4+4=25
REDUCE CENTER CELL

Fig.8

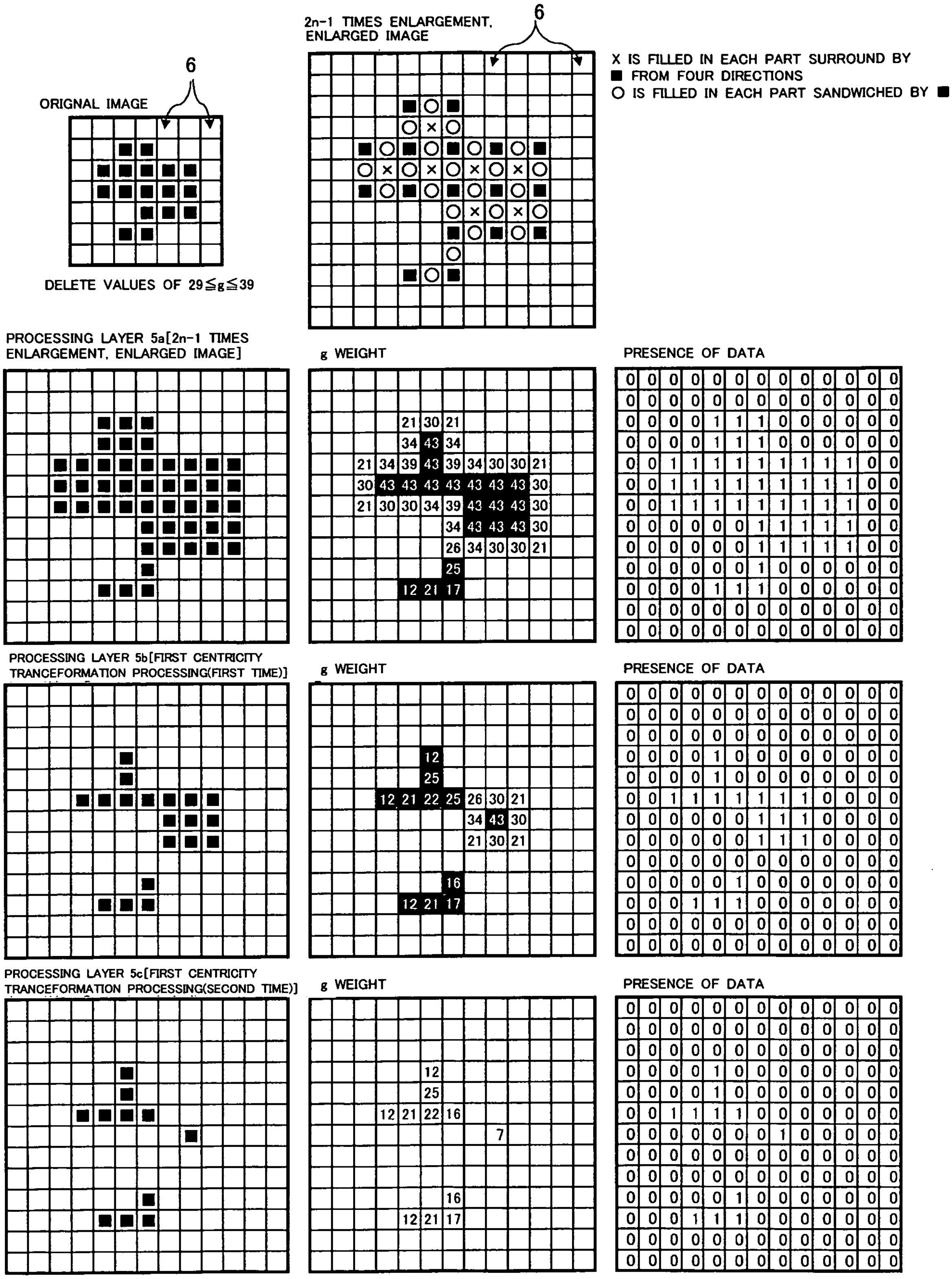
2n-1 TIMES ENLARGEMENT, ENLARGED IMAGE
6
X IS FILLED IN EACH PART SURROUND BY ■ FROM FOUR DIRECTIONS
O IS FILLED IN EACH PART SANDWICHED BY ■
6
ORIGNAL IMAGE
DELETE VALUES OF 29≦g≦39
PROCESSING LAYER 5a[2n-1 TIMES ENLARGEMENT, ENLARGED IMAGE]
g WEIGHT
PRESENCE OF DATA
PROCESSING LAYER 5b[FIRST CENTRICITY TRANCEFORMATION PROCESSING(FIRST TIME)]
g WEIGHT
PRESENCE OF DATA
PROCESSING LAYER 5c[FIRST CENTRICITY TRANCEFORMATION PROCESSING(SECOND TIME)]
g WEIGHT
PRESENCE OF DATA

Fig.9

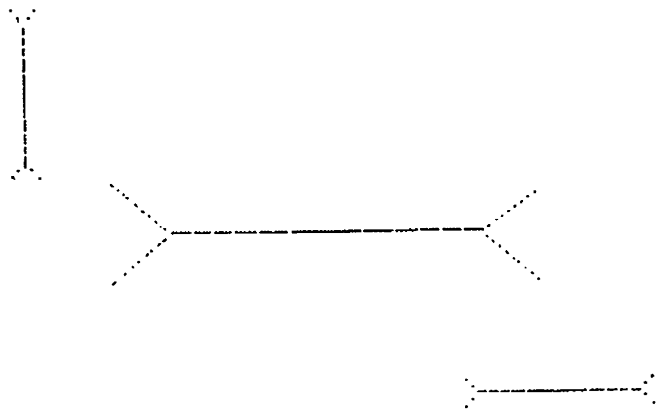

Fig.10

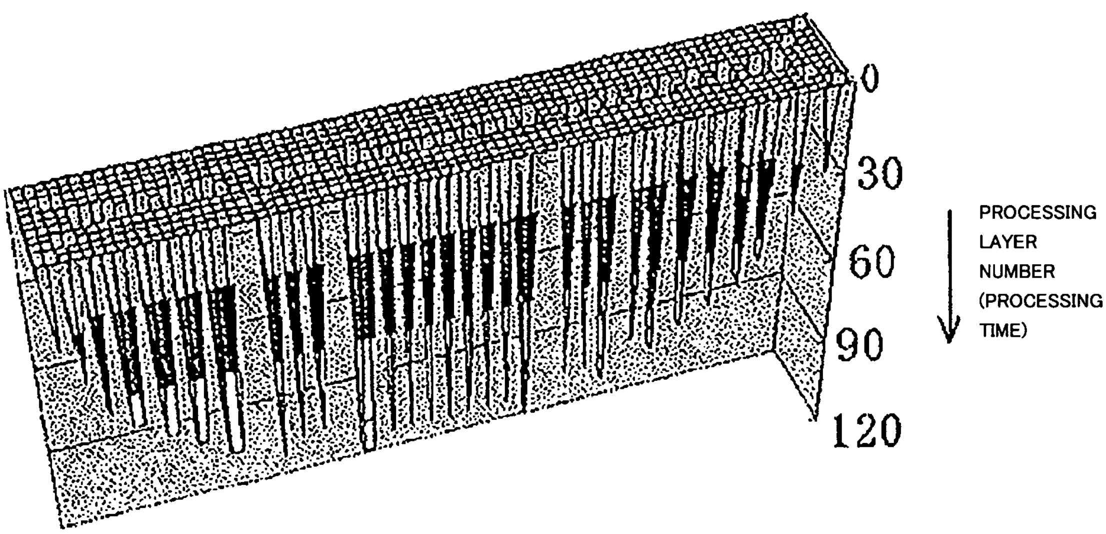

Fig.11

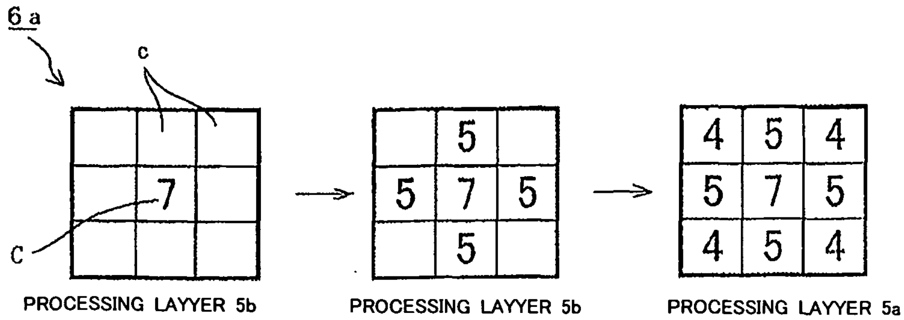
6 a
c
C
7
5
5 7 5
5
4 5 4
5 7 5
4 5 4
PROCESSING LAYYER 5b
PROCESSING LAYYER 5b
PROCESSING LAYYER 5a

Fig.12

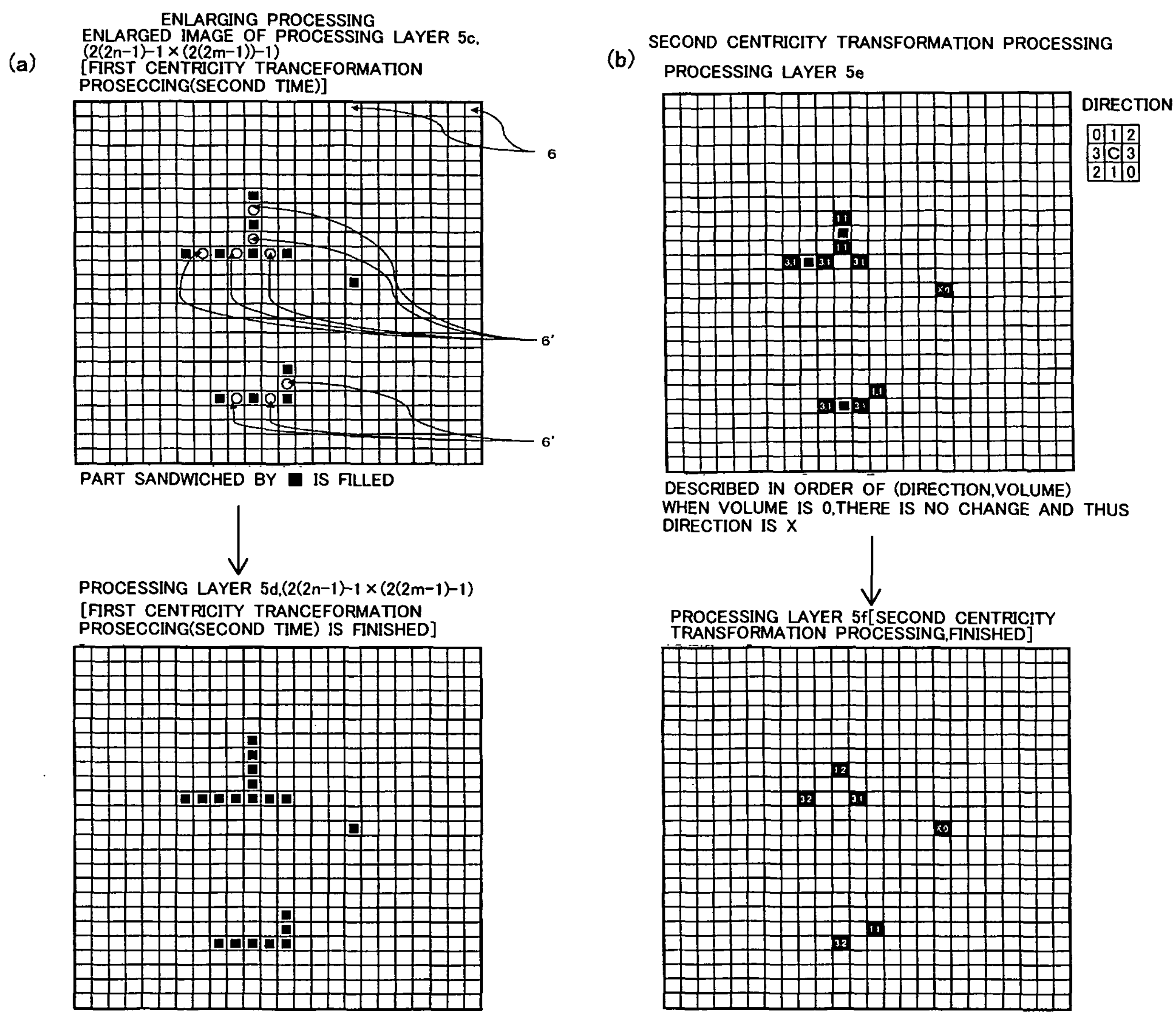
(a)
ENLARGING PROCESSING
ENLARGED IMAGE OF PROCESSING LAYER 5c, (2(2n-1)-1 × (2(2m-1))-1)
[FIRST CENTRICITY TRANCEFORMATION PROSECCING(SECOND TIME)]
6
6'
6'
PART SANDWICHED BY ■ IS FILLED
PROCESSING LAYER 5d,(2(2n-1)-1 × (2(2m-1)-1)
[FIRST CENTRICITY TRANCEFORMATION PROSECCING(SECOND TIME) IS FINISHED]
(b)
SECOND CENTRICITY TRANSFORMATION PROCESSING
PROCESSING LAYER 5e
DIRECTION
0 1 2
3 C 3
2 1 0
DESCRIBED IN ORDER OF (DIRECTION,VOLUME)
WHEN VOLUME IS 0,THERE IS NO CHANGE AND THUS DIRECTION IS X
PROCESSING LAYER 5f[SECOND CENTRICITY TRANSFORMATION PROCESSING,FINISHED]

Fig.13

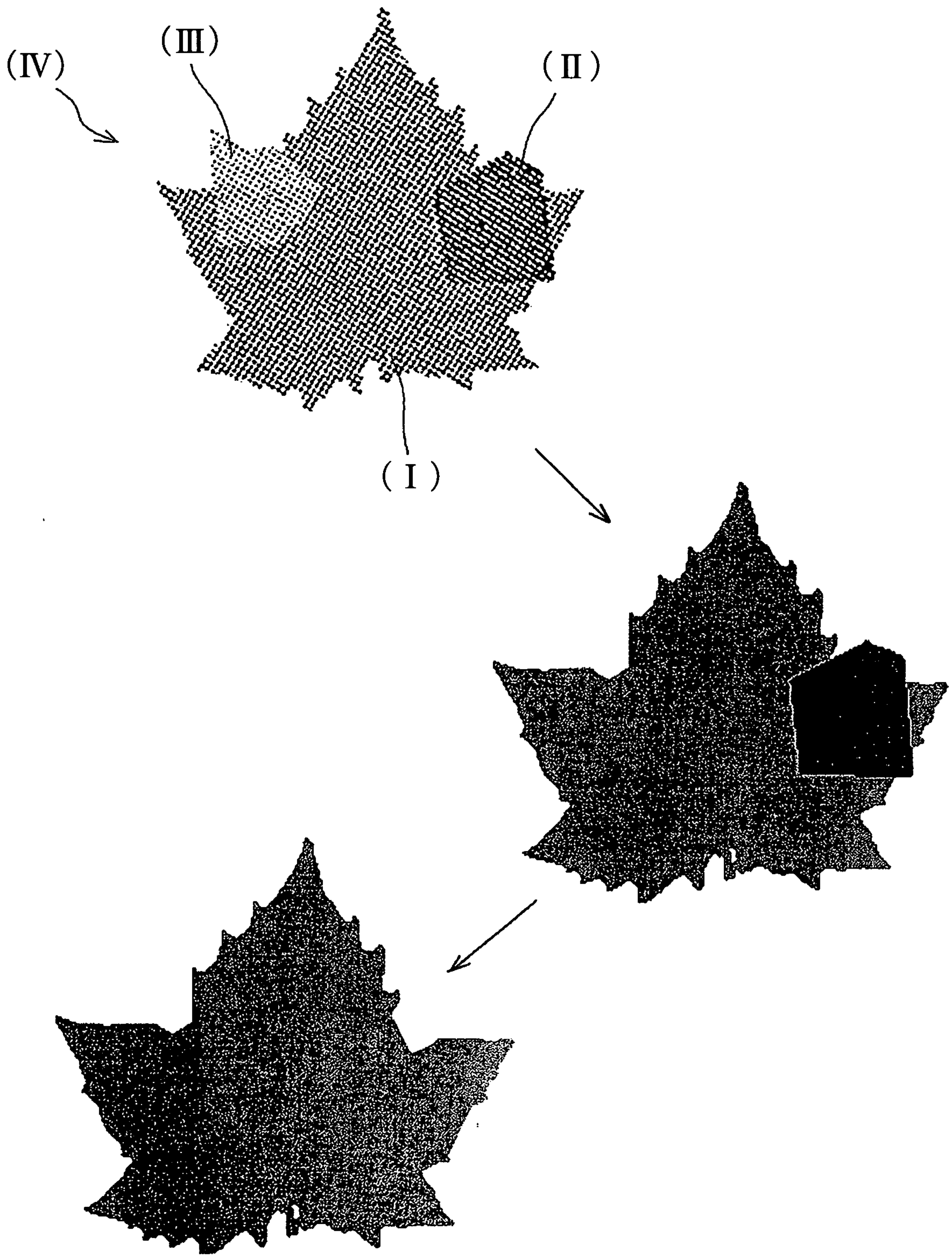

Fig.14

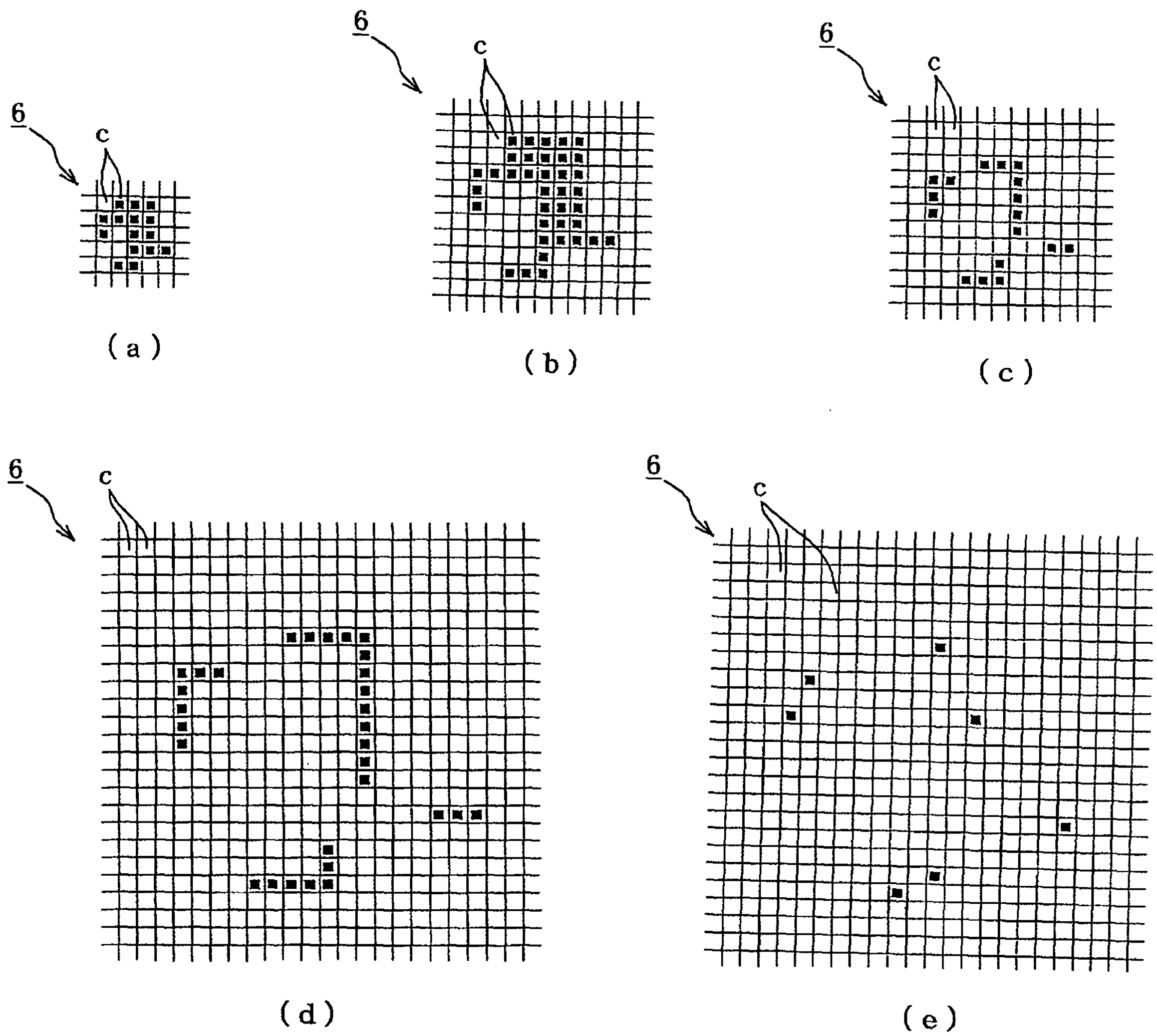

Fig.15

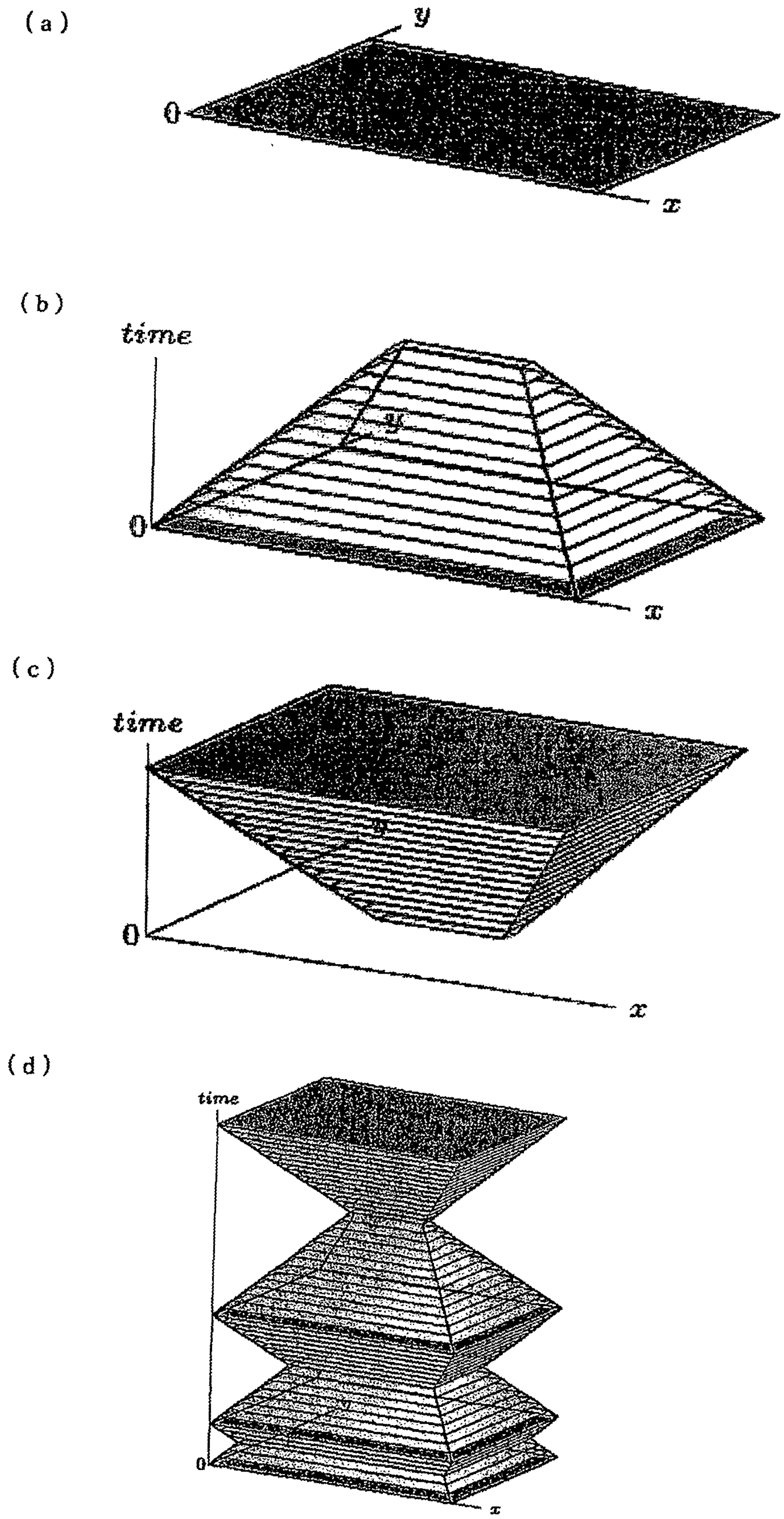

Fig.16

| (X,Y,Z) | VALUES IN (X,Y,Z) PARTS | PRESENCE OF DATA AT (X,Y,Z) |
|---|---|---|
| (0,0,3) | 5 | 1 |
| (0,1,3) | 0 | 0 |
| (1,0,3) | 0 | 0 |
| (1,1,3) | 0 | 0 |
| (2,0,3) | 0 | 0 |
| (2,1,3) | 0 | 0 |
| (0,0,2) | 0 | 0 |
| (0,1,2) | 0 | 0 |
| (1,0,2) | 0 | 0 |
| (1,1,2) | 3 | 1 |
| (2,0,2) | 0 | 0 |
| (2,1,2) | 2 | 1 |
| (0,0,1) | 0 | 0 |
| (0,1,1) | 0 | 0 |
| (1,0,1) | 0 | 0 |
| (1,1,1) | 6 | 1 |
| (2,0,1) | 0 | 0 |
| (2,1,1) | 0 | 0 |
| (0,0,0) | 0 | 0 |
| (0,1,0) | 0 | 0 |
| (1,0,0) | 0 | 0 |
| (1,1,0) | 3 | 1 |
| (2,0,0) | 0 | 0 |
| (2,1,0) | 7 | 1 |

Fig.17

| (X, Y) | PRESENCE OF DATA WHEN XY PLANE IS SEEN IN Z-AXIS DIRECTION | (X, Y) | NUMBER OF DATA WHEN XY PLANE IS SEEN IN Z-AXIS DIRECTION |
|---|---|---|---|
| (0, 0) | 1 | (0, 0) | 1 |
| (0, 1) | 0 | (1, 1) | 3 |
| (1, 0) | 0 | (2, 1) | 2 |
| (1, 1) | 1 | | |
| (2, 0) | 0 | | |
| (2, 1) | 1 | | |

Fig.18

| (X, Y, Z) | PRESENCE DATA WHEN SEEN IN ORDER DOWNWARD FROM UPPER LAYER TO LOWER LAYER FROM ABOVE TABLE | (X, Y, Z) | DATA VALUE WHEN SEEN IN ORDER DOWNWARD FROM UPPER LAYER TO LOWER LAYER FROM ABOVE TABLE |
|---|---|---|---|
| (0,0,3) | 1 | (0,0,3) | 5 |
| (1,1,3) | 0 | (1,1,2) | 3 |
| (2,1,3) | 0 | (2,1,2) | 2 |
| (1,1,2) | 1 | (2,1,1) | 6 |
| (2,1,2) | 1 | (1,1,0) | 3 |
| (1,1,1) | 0 | (2,1,0) | 7 |
| (2,1,1) | 1 | | |
| (1,1,0) | 1 | | |
| (2,1,0) | 1 | | |

Fig.19

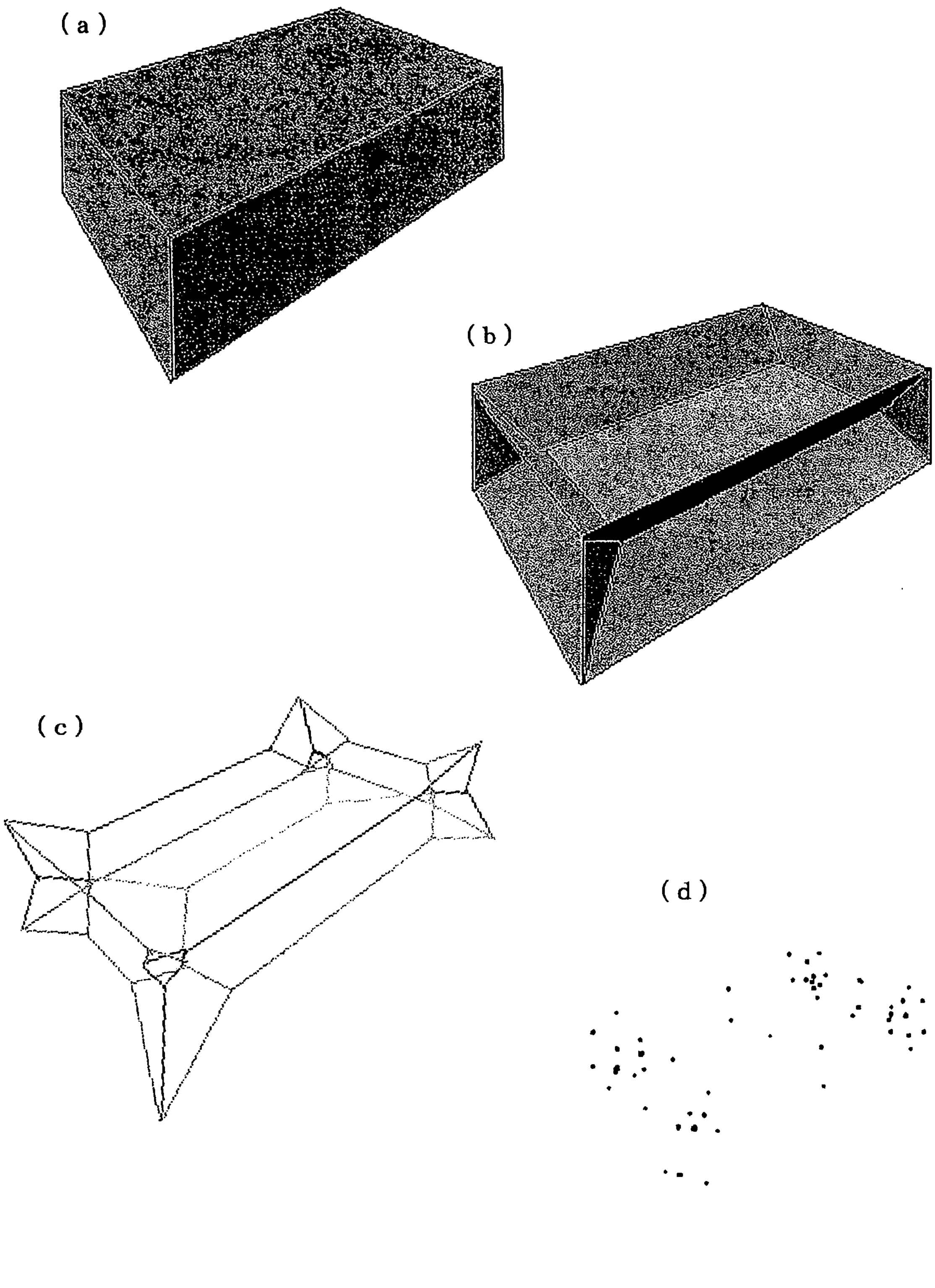

Fig.20

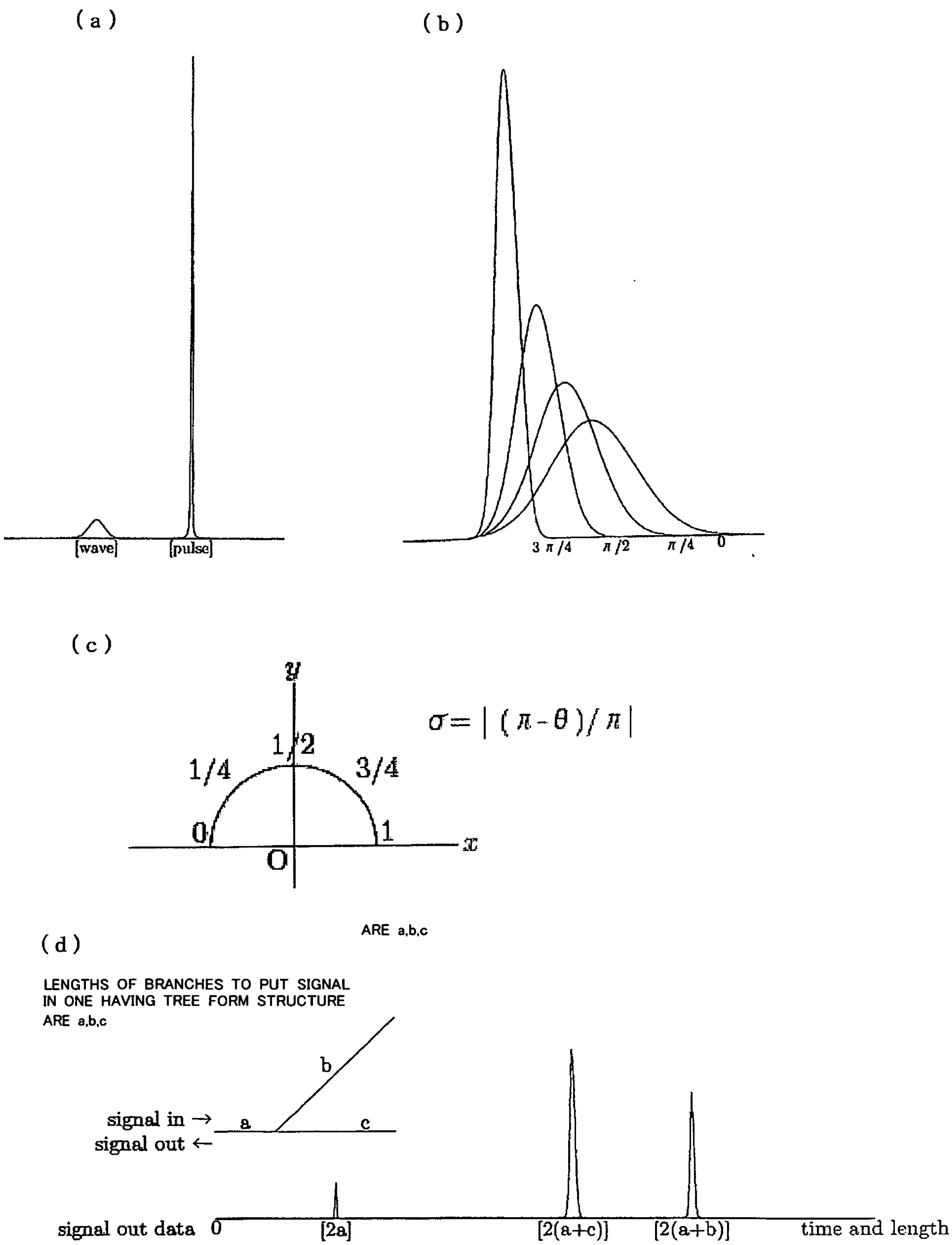
(a)
[wave]
[pulse]
(b)
3 π/4
π/2
π/4
0
(c)
y
1/2
1/4
3/4
0
1
O
x
σ= | (π-θ)/π |
ARE a,b,c
(d)
LENGTHS OF BRANCHES TO PUT SIGNAL
IN ONE HAVING TREE FORM STRUCTURE
ARE a,b,c
b
signal in →
signal out ←
a
c
signal out data
0
[2a]
[2(a+c)]
[2(a+b)]
time and length

Fig.21

(a)

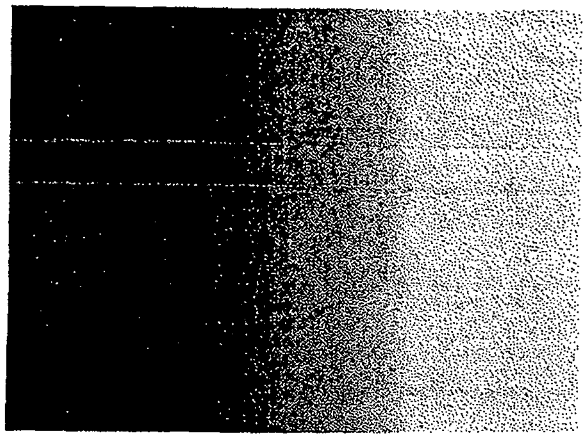

(b)

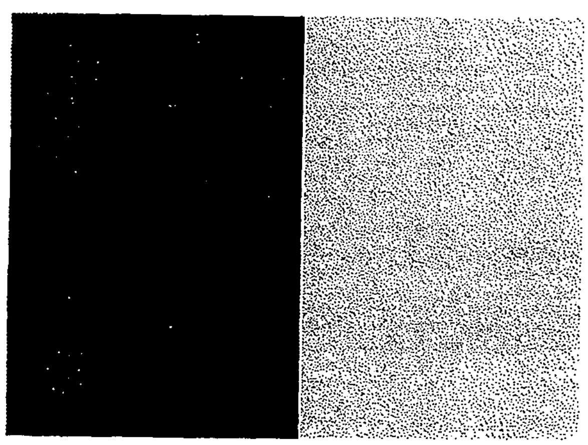

**INTERNATIONAL SEARCH REPORT**

International application No.
PCT/JP2009/069299

A. CLASSIFICATION OF SUBJECT MATTER
*H03M7/30*(2006.01)i, *H04N1/41*(2006.01)i

According to International Patent Classification (IPC) or to both national classification and IPC

B. FIELDS SEARCHED

Minimum documentation searched (classification system followed by classification symbols)
H03M7/30, H04N1/41

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-510979 A (Electronics and Telecommunications Research Institute), 21 April 2005 (21.04.2005), entire text; all drawings & US 2005/0013357 A1 & EP 1449381 A & WO 2003/047263 A1 & KR 10-2003-0043612 A & CN 1613258 A | 1-19 |
| A | JP 2006-262436 A (Toshiba Corp.), 28 September 2006 (28.09.2006), entire text; all drawings & US 2006/0209346 A1 | 1-19 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 January, 2010 (08.01.10) | 19 January, 2010 (19.01.10) |
| Name and mailing address of the ISA/ Japanese Patent Office | Authorized officer |
| Facsimile No. | Telephone No. |

Form PCT/ISA/210 (second sheet) (April 2007)

**INTERNATIONAL SEARCH REPORT**

International application No.
PCT/JP2009/069299

C (Continuation). DOCUMENTS CONSIDERED TO BE RELEVANT

| Category* | Citation of document, with indication, where appropriate, of the relevant passages | Relevant to claim No. |
|---|---|---|
| P,X | Nagato OYA, "Chushinsei Shugo Gainen o Tsukatta Gazo Asshuku Gijutsu Sogata System ni yoru Morphology Gazo Shori", Nippon Mizar Gakkai 2009 Nen Shunki Sokai Yokoshu, 2009.06, MS2009008, pages 1 to 9 | 1-19 |
| P,A | Nagato OYA, "n-jigen Kukan no Chushinsei Shugo Gainen", Proceedings of the Technical Symposium and General Assembly opf Mizar JAPAN (Autumn 2008), 15 November 2008 (15.11.2008), vol.3, no.2, pages 16 to 19 | 1-19 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 200456084 A

### Non-patent literature cited in the description

- Reconstruction of Natural Scenes from Ensemble Responses in the Lateral Geniculate Nucleus. *J. Neuroscience,* 1999, vol. 19, 8036-8042
- Image compression technology using the centricity concept. *journal of the Japan Society for Symbolic and Algebraic Computation,* vol. 16 (2